# EUROPÄISCHE PATENTSCHRIFT

(11) **EP 4 314 388 B1**
(45) Veröffentlichungstag und Bekanntmachung des Hinweises auf die Patenterteilung: **11.11.2026**
(21) Anmeldenummer: 23706763.2
(22) Anmeldetag: 22.02.2023
(51) Int. Cl.: C23F 1/08, C25F 7/00, C25F 3/02, B23H 3/00, B23H 9/00, H05K 3/06

(54) **ÄTZVORRICHTUNG UND ÄTZSYSTEM**
ETCHING DEVICE AND ETCHING SYSTEM
DISPOSITIF DE GRAVURE ET SYSTÈME DE GRAVURE

(30) Priorität: 24.02.2022 DE 102022104460
(43) Veröffentlichungstag der Anmeldung: 07.02.2024
(73) Patentinhaber: Steinbeis Transfer GmbH, 70599 Stuttgart (DE); Cloeren Technology GmbH, 41372 Niederkrüchten (DE)
(72) Erfinder: BRITZ, Dominik, 66798 Wallerfangen (DE); MÜCKLICH, Frank, 66773 Schwalbach (DE); CLOEREN, Heinz-Hubert, 41372 Niederkrüchten (DE); BÜLBÜL, Berat, 41812 Erkelenz (DE)
(74) Vertreter: Lichti - Patentanwälte Partnerschaft mbB
(86) Internationale Anmeldenummer: PCT/EP2023/054397
(87) Internationale Veröffentlichungsnummer: WO 2023/161265

(56) Entgegenhaltungen:
- EP-A2- 3 505 298
- CN-A- 113 838 784
- DE-A1- 102008 043 940
- FR-A- 1 497 475
- US-A- 3 538 838
- US-A- 6 039 835
- US-A1- 2010 236 717

## Beschreibung

Die Erfindung betrifft eine Ätzvorrichtung für ein zu bearbeitendes Werkstück mittels einer Ätzflüssigkeit sowie ein Ätzsystem mit der Ätzvorrichtung.

Ätzvorrichtungen dienen zur chemischen Bearbeitung von Werkstücken. Hierbei wird die Ätzflüssigkeit, die auch Beize genannt wird, auf eine zu bearbeitende Oberfläche des Werkstücks aufgebracht. Zwischen der Ätzflüssigkeit und der Werkstückoberfläche findet eine chemische Reaktion statt, wobei die Werkstückoberfläche abgetragen und eine Vertiefung ausgebildet wird. Auf diese Weise können insbesondere metallische Werkstücke benutzerdefiniert strukturiert oder elektrische Leiterbahnen auf Platinen in der Elektronikfertigung ausgebildet werden. Ebenso kann die Werkstückoberfläche mit einem heterogenen Gefüge für eine Werkstoffprüfung kontrastiert werden. Bei sogenannten Farbätzungen können unterschiedliche Schichten einer Werkstückoberfläche selektiv eingefärbt werden.

Eine Ätzvorrichtung und ein Ätzsystem mit einer Ätzvorrichtung werden in CN 113 838 784 A und US 6 039 835 A offenbart.

Es ist wünschenswert, die chemische Reaktion zwischen der Ätzflüssigkeit und der zu bearbeitenden Werkstückoberfläche möglichst genau zu untersuchen und prozesstechnisch zu steuern, um eine hohe Ätzqualität zu erreichen.

Die bekannten Ätzvorrichtungen haben den Nachteil, dass das Ätzen des Werkstücks empirisch optimiert werden muss, da keine zuverlässige Überwachung des Ätzvorgangs, insbesondere in-situ, also während des Ätzprozesses, gegeben ist.

Es ist daher die Aufgabe der Erfindung, unter Vermeidung der Nachteile aus dem Stand der Technik eine Ätzvorrichtung zu entwickeln, die zeit- und kostengünstig einen optimierten Ätzvorgang ermöglicht. Entsprechendes gilt für das Ätzsystem.

Die Aufgabe der Erfindung wird gelöst durch eine Ätzvorrichtung für ein zu bearbeitendes Werkstück mittels einer Ätzflüssigkeit mit einem Hohlraum, in den das Werkstück einbringbar ist, wobei der Hohlraum zumindest bereichsweise von mindestens einer Arretierung der Ätzvorrichtung für das Werkstück umgeben ist, wobei die Arretierung und eine der Arretierung zugewandte Stirnseite der Ätzvorrichtung teilweise einen Zwischenraum zum Einbringen der Ätzflüssigkeit umgeben und wobei die der Arretierung zugewandte Stirnseite der Ätzvorrichtung zumindest bereichsweise transparent ausgestaltet ist. Daneben wird die Aufgabe der Erfindung gelöst durch ein Ätzsystem mit einer erfindungsgemäßen Ätzvorrichtung, wobei die Ätzvorrichtung über mindestens eine Ätzflüssigkeitszulaufleitung mit mindestens einer Ätzflüssigkeitsquelle und über mindestens eine Ätzflüssigkeitsablaufleitung mit mindestens einem Ätzflüssigkeitsreservoir verbunden ist.

Die Erfindung basiert auf dem Grundgedanken, dass mit der Arretierung konstruktionsbedingt ein einfach vorzusehender, reproduzierbarer Anschlag für die zu bearbeitende Oberfläche des Werkstücks gegeben ist. Daneben befindet sich die zu bearbeitende Oberfläche des Werkstücks insbesondere während des Ätzprozesses stets in dem gleichen, vordefinierten Abstand zur transparent ausgestalteten Stirnseite der Ätzvorrichtung, wodurch eine besonders einfache visuelle in situ-Inspektion ermöglicht wird, um den Ätzprozess einfach und effektiv zu optimieren.

Im Folgenden werden Richtungsangaben in Anlehnung an ein zylindrisches Koordinatensystem beschrieben; dabei entspricht eine axiale Richtung einer vertikalen Richtung, wobei eine radiale Richtung und eine Umfangsrichtung jeweils horizontal und damit senkrecht zur axialen Richtung ausgerichtet sind.

Zur Verbesserung der Beständigkeit kann die Ätzvorrichtung ein Gehäuse aus ätzbeständigem Material aufweisen, insbesondere in einem zum Hohlraum benachbart angeordneten Bereich. Bevorzugt weist das Gehäuse eine verschließbare Öffnung auf, durch die das zu bearbeitende Werkstück in den Hohlraum eingebracht werden kann. Das Werkstück kann an einem Werkstückhalter anbringbar sein, der insbesondere aus einem ätzbeständigen Material hergestellt ist, und dessen Abmessungen vorzugsweise an die Abmessungen der Ätzvorrichtung angepasst sind. Durch Einbringen des Werkstücks in den Hohlraum gelangt das Werkstück und/oder der Werkstückhalter vorzugsweise zumindest bereichsweise in Kontakt mit der Arretierung und verbleibt während des darauffolgenden Ätzprozesses in einer Position, die durch die Position und/oder die Geometrie der Arretierung vorgebbar ist.

Vorzugsweise ist die mindestens eine Arretierung derart angeordnet, dass die zu bearbeitende Werkstückoberfläche parallel zu dem transparenten Bereich der zur Arretierung zugewandten Stirnseite ausgerichtet ist, um optische Abbildungsfehler zu vermeiden.

Vorzugsweise ist die Arretierung an einer seitlichen Innenwandung des Hohlraums angeordnet. In einer konstruktiv einfachen Ausgestaltung der Erfindung kann die Arretierung als mindestens ein Vorsprung zwischen dem Hohlraum und dem Zwischenraum ausgestaltet sein. Der Zwischenraum kann im Sinne der Erfindung insbesondere ein Teil des Hohlraums und/oder mit diesem verbunden sein. Die Arretierung kann als ein zum Hohlraum, insbesondere radial nach innen gerichteter Vorsprung ausgebildet sein, wobei mehrere Vorsprünge über den Umfang der Innenwandung verteilt angeordnet sein können. Bevorzugt ist die Arretierung ring- oder rahmenförmig in Umfangsrichtung ausgebildet. Dadurch können ein im Hohlraum angeordnetes Werkstück und/oder der Werkstückhalter, an dem das Werkstück anbringbar ist, randseitig an der ring- oder rahmenförmigen Arretierung anliegen und werden zuverlässig an dieser gehalten. In einer solchen Anordnung können die Arretierung sowie die Innenwandung des Hohlraums, an der die Arretierung angeordnet sein kann, teilweise den Zwischenraum begrenzen. Gleichzeitig kann der Zwischenraum zu einer Seite durch das Werkstück und/oder den Werkstückhalter begrenzt werden, die randseitig an der Arretierung anliegen. Die zu ätzende Werkstückoberfläche kann hierbei zum Zwischenraum weisen. In den Zwischenraum eingebrachte Ätzflüssigkeit kann auf diese Weise auf die zu bearbeitende Werkstückoberfläche gelangen, wobei das Werkstück eine geometrisch vordefinierte, reproduzierbare Position einnimmt und durch den transparenten Bereich der zur Arretierung zugewandten Stirnseite der Ätzvorrichtung einsehbar ist.

Der transparente Bereich der zur Arretierung zugewandten Stirnseite kann als in eine Vertiefung der Stirnseite eingefügter Glas- und/oder Kunststoffeinsatz, insbesondere als eingefügte Glasscheibe, ausgestaltet sein. Insbesondere kann der Glaseinsatz ein optisches Glas aufweisen, das sich in seiner chemischen Zusammensetzung von gewöhnlichem Fensterglas unterscheidet und üblicherweise zur Herstellung optischer Elemente, wie Linsen, Spiegeln oder Prismen verwendet wird. Die Verwendung von optischem Glas begünstigt die optische Überwachung des Ätzprozesses mittels der erfindungsgemäßen Ätzvorrichtung, insbesondere in Kombination mit einem optischen Sensor, der beispielsweise als Mikroskop ausgebildet ist. Im Sinne der Erfindung bezeichnet transparent eine für die visuelle Inspektion des Ätzprozesses ausreichende Transmissionsfähigkeit für den konkret verwendeten Wellenlängenbereich, der den optisch sichtbaren Wellenlängenberiech umfasst, aber nicht notwendigerweise auf diesen beschränkt ist. Die Glasscheibe kann zur Vertiefung korrespondierend, kreisförmig ausgestaltet und/oder radial zentriert an der Stirnseite angeordnet sein. Vorzugsweise weist die Glasscheibe einen Durchmesser zwischen 90 mm und 100 mm und/oder eine Dicke von etwa 1 mm auf.

Vorzugsweise ist im Hohlraum mindestens ein Klemmelement derart vorgesehen, dass das in den Hohlraum einbringbare Werkstück und/oder der Werkstückhalter, an dem das Werkstück anbringbar ist, mit der Arretierung verklemmbar ist. Das Klemmelement kann hierzu dazu ausgestaltet sein, das in den Hohlraum einbringbare Werkstück und/oder der Werkstückhalter mit einer zur Arretierung gerichteten Kraft zu beaufschlagen. Dadurch wird sichergestellt, dass auch Werkstücke mit verschiedenen Geometrien stets in Anlage mit der Arretierung gelangen, so dass sich die zu bearbeitende Werkstückoberfläche in einem vordefinierten Abstand zum transparenten Bereich der Stirnseite der Ätzvorrichtung befindet. Beispielsweise ist das Klemmelement in Richtung der Arretierung, insbesondere linear beweglich.

In einer besonders einfachen konstruktiven Ausgestaltung weist das Klemmelement mindestens ein Federelement auf, wobei das Federelement als Schrauben- und/oder als Metallfeder ausgebildet sein kann. Alternativ oder zusätzlich dazu kann das Klemmelement einen insbesondere linear verfahrbaren Schlitten aufweisen, der mit einer Kraft in Richtung der Arretierung beaufschlagt sein kann.

In einer vorteilhaften Weiterbildung der Erfindung ist in dem Hohlraum eine Werkstückaufnahme angeordnet, um das zu bearbeitende Werkstück und/oder den in den Hohlraum einbringbaren Werkstückhalter, an welchem das Werkstück anbringbar ist, aufzunehmen, wobei insbesondere die Werkstückaufnahme das Klemmelement aufweist.

Im Sinne der Erfindung dient die Werkstückaufnahme dazu, das Werkstück und/oder den Werkstückhalter, an dem das Werkstück anbringbar ist, aufzunehmen, um diese innerhalb des Hohlraums in einer definierten Lage positionieren zu können. Die Werkstückaufnahme weist vorzugsweise eine Anschlagskante für das Werkstück auf, die die Auflagefläche des Werkstücks seitlich, also radial begrenzt und die Position des Werkstücks vorgibt. Bevorzugt kann die Werkstückaufnahme einen Innenraum mit zumindest einem Klemmelement aufweisen, mit dem das Werkstück für den Ätzprozess positionierbar und fixierbar ist. Die Werkstückaufnahme ist vorzugsweise derart in dem Hohlraum angeordnet, dass das hierauf anordbare Werkstück mit seiner zu bearbeitenden Werkstückoberfläche in Richtung des Zwischenraums weist. Die Werkstückaufnahme kann, insbesondere bei verschlossener Ätzvorrichtung, vollständig im Hohlraum angeordnet sein und/oder, bei geöffneter Ätzvorrichtung, teilweise aus dem Hohlraum ragen. Die Werkstückaufnahme kann insbesondere mittels eines Lagers beweglich in dem Hohlraum angeordnet sein und/oder kann mittels eines Feststellelements in einer definierten Position fixierbar sein. In einer vorteilhaften Weiterbildung der Erfindung ist die Werkstückaufnahme zylinderförmig, insbesondere hohlzylinderförmig ausgestaltet.

In einer vorteilhaften Weiterbildung der Erfindung ist die Werkstückaufnahme teleskopierbar ausgestaltet, beispielsweise als insbesondere zwei vorzugsweise ineinander geführte Zylinderhülsen, die einen gemeinsamen Innenraum ausbilden. Über eine stirnseitige Öffnung können das Werkstück und/oder der Werkstückhalter mit dem Werkstück in den Innenraum der Werkstückaufnahme angeordnet werden. Im Sinne eines platzsparenden Aufbaus kann das Klemmelement, insbesondere die Schraubenfeder, im Innenraum der Werkstückaufnahme angeordnet sein und insbesondere über die Innenwandung der Werkstückaufnahme beweglich geführt sein. Dadurch kann die Innenwandung der Werkstückaufnahme eine Verstellachse für das Klemmelement und das darauf positionierbare Werkstück und/oder den Werkstückhalter definieren.

Die erste Zylinderhülse der Werkstückaufnahme kann einen geringfügig größeren Innendurchmesser als der Außendurchmesser der zweiten Zylinderhülse der Werkstückaufnahme aufweisen. Dadurch lassen sich die Zylinderhülsen insbesondere übereinander führen, so dass diese über einen gemeinsamen Kontaktbereich relativ zueinander und entlang einer gemeinsamen Längsachse verschiebbar sind. Vorzugsweise ist die Werkstückaufnahme zumindest teilweise aus ätzbeständigem Material, beispielsweise Polytetrafluorethylen (PTFE) gefertigt.

In einer vorteilhaften Weiterbildung ist ein in den Hohlraum, insbesondere in den Zwischenraum mündender Zulaufkanal für die Ätzflüssigkeit zumindest abschnittsweise in Richtung des Hohlraums, insbesondere in Richtung des Zwischenraums verbreiternd ausgestaltet, insbesondere stetig verbreiternd. Beispielsweise sind die Seitenwände in dem sich verbreiternden Abschnitt des Zulaufkanals nicht parallel zueinander ausgerichtet sondern schließen einen endlichen, spitzen Winkel zwischen sich ein. Vorzugsweise ist der Zulaufkanal über einen horizontalen, insbesondere radialen Abschnitt verbreiternd ausgestaltet. Im Sinne der Erfindung gelangt die Ätzflüssigkeit über den Zulaufkanal in den Zwischenraum und damit zu der zu bearbeitenden Oberfläche des Werkstücks. Es hat sich gezeigt, dass durch die sich verbreiternde Ausgestaltung des Zulaufkanals die Bildung von Luftblasen wesentlich verringert ist gegenüber einem Zulaufkanal mit einer konstanten Breite. Der Ätzvorgang wird durch die dadurch erzielte Homogenisierung der Ätzflüssigkeit verbessert. Der Zulaufkanal kann insbesondere abschnittsweise zwischen der Arretierung und der zur Arretierung zugewandten Stirnseite der Ätzvorrichtung ausgebildet sein. der Durchmesser des Zulaufkanals kann größer sein als der Durchmesser des Ablaufkanals, insbesondere in einem zum Zwischenraum gerichteten Abschnitt. Vorzugsweise ist der Zulaufkanal, insbesondere dessen horizontaler, höchst vorzugsweise dessen verbreitender Abschnitt als Nut ausgestaltet, die von den Seitenwänden umgeben ist und beispielsweise eine Tiefe von 1 mm aufweist.

In einer bevorzugten Ausgestaltung ist das Klemmelement elektrisch leitend mit einem elektrischen Anschluss verbunden, um das in den Hohlraum einbringbare Werkstück elektrisch kontaktieren. Dadurch wird ein elektrolytischer Ätzvorgang mit der erfindungsgemäßen Ätzvorrichtung möglich, der auch als Elektroätzen bekannt ist. Hierbei wird die zu bearbeitende Oberfläche des Werkstücks unter Verwendung eines elektrischen Stroms abgetragen. Das Werkstück ist dadurch elektrisch kontaktierbar. Bei dieser Art des Ätzens können im Vergleich zum rein chemischen Ätzen weniger korrosive Ätzflüssigkeiten verwendet werden, um das Werkstück zu bearbeiten. Die Ätzflüssigkeit dient dabei als Elektrolyt und das elektrisch mit dem Anschluss verbundene Werkstück als Elektrode, insbesondere als Anode. Es liegt dabei im Rahmen des fachmännischen Könnens, eine zweite, vorzugsweise aus Edelmetall bestehende Elektrode als Kathode an einer geeigneten Position innerhalb oder außerhalb der Ätzvorrichtung in die Ätzflüssigkeit zu tauchen. Vorzugsweise ist die Kathode derart im Hohlraum angeordnet, dass die Kathode bei dem Ätzvorgang elektrisch leitend mit der Ätzflüssigkeit verbunden ist. Die Kathode ist vorzugsweise lösbar mit der Ätzvorrichtung verbunden, so dass die Kathode austauschbar ist. Eine konstruktiv einfache Weiterbildung der Erfindung kann vorsehen, dass die Kathode zylinderförmig ausgestaltet ist.

Durch Anlegen einer Spannung zwischen der Anode und der Kathode fließt ein Strom, wobei sich Ionen aus der Anode, hier also dem Werkstück, lösen und durch die Ätzflüssigkeit als Elektrolyt zur Kathode gelangen. Die besagten Ionen des Werkstücks scheiden sich ab oder fallen aus der Lösung als Niederschlag auf der Kathode aus. Hierdurch wird die Werkstückoberfläche an den gewünschten Stellen geätzt.

Vorzugsweise ist die Kathode innerhalb des Hohlraums derart angeordnet, dass sie während des elektrolytischen Ätzvorgangs keinen mechanischen Kontakt zu dem Werkstück hat, um einen elektrischen Kurzschluss zu vermeiden.

Vorzugsweise kann insbesondere im Hohlraum ein Heizelement angeordnet sein, das dazu ausgestaltet ist, die in den Zwischenraum eingebrachte Ätzflüssigkeit auf eine benutzerdefinierte Temperatur zu heizen. Dadurch ist es möglich, das Werkstück auch thermisch zu ätzen. Ein derartiges Ätzverfahren beruht auf der Erkenntnis, dass durch eine gewünschte Temperierung der Ätzflüssigkeit das Ergebnis des Ätzprozesses maßgeblich beeinflusst und gesteuert, mithin optimiert werden kann. Hierfür kann das Heizelement in einfacher Weise in dem Hohlraum der Ätzvorrichtung angeordnet und/oder als Heizplatte ausgestaltet sein.

Das Heizelement kann als elektrisches Heizelement ausgestaltet sein, das zugeführte elektrische Energie in Wärme umwandeln kann. In einer konstruktiv einfachen Ausgestaltung der Erfindung ist das Heizelement im Bereich des Zulaufkanals angeordnet, so dass die Ätzflüssigkeit beim Durchströmen des Zulaufkanals in Richtung des zu bearbeitenden Werkstücks auf eine benutzerdefinierte Temperatur geheizt und so in Kontakt mit dem Werkstück gelangen kann. Das Heizelement kann als Heizplatte ausgestaltet sein, die insbesondere in der Werkstückaufnahme angeordnet ist.

Zusätzlich zum Heizelement kann mindestens ein Temperatursensor vorgesehen sein, um die Temperatur der Ätzvorrichtung, insbesondere der Ätzflüssigkeit zu bestimmen und zu überwachen. Bevorzugt weist der Hohlraum und/oder die Werkstückaufnahme den Temperatursensor auf, vorzugsweise in deren Innenraum. Vorzugsweise ist ein Magnetrührer oder ein drehbarer Strömungspropeller vorgesehen, die dazu ausgestaltet sind, eine gleichmäßige Benetzung der Werkstückoberfläche mit Ätzflüssigkeit zu bewirken. Hierzu können der Magnetrührer und/oder der Strömungspropeller in einer stromauf zum Zwischenraum angeordneten Ätzflüssigkeitsleitung und/oder im Zulaufkanal angeordnet sein. Dadurch kann ein gleichmäßiger und homogener Materialabtrag an der zu ätzenden Werkstückoberfläche erreicht werden, die im Sinne der Erfindung als Werkstückprobe bezeichnet wird. Mikroskopisch betrachtet werden die infolge des Ätzprozesses entstehenden Ionen des Werkstücks optimiert abtransportiert, so dass den Ätzprozess störende statische Effekte vermieden und im Ergebnis auch ein reproduzierbares Ätzergebnis erhalten werden können. Das Heizelement kann im Hohlraum der Ätzvorrichtung, beispielsweise als Heizplatte, angeordnet und/oder mit dem Klemmelement verbunden sein.

Vorzugsweise weist eine Auflagefläche der Ätzvorrichtung, die insbesondere als mindestens ein Standfuß ausgebildet ist, einen Drucksensor auf. Im Sinne der Erfindung vermag ein Drucksensor, eine auf die Ätzvorrichtung in Richtung einer Unterlage, auf der die Ätzvorrichtung angeordnet ist, gerichteten Kraft zu bestimmen. Der Drucksensor registriert damit in der Regel die Gewichtskraft der Ätzvorrichtung aber auch eine gegenüber dieser vergrößerten Kraft, falls externe Komponenten beispielsweise auf die Ätzvorrichtung abgelegt werden oder mit dieser in Kontakt gelangen. Insbesondere weist jeder Standfuß einen Drucksensor auf. Der Drucksensor kann mit einer Auswerteeinheit verbunden sein, die die vom Drucksensor bestimmte Kraft ausliest und mit einem definierten Grenzwert vergleicht, so dass beispielsweise bei einem Überschreiten des Grenzwertes ein Warnsignal ausgegeben wird, das auf eine drohende Beschädigung der Ätzvorrichtung in Folge der auf diese wirkenden Kraft hinweist. Das Warnsignal kann optisch und/oder akustisch sein. Auf diese Weise kann insbesondere dann, wenn während der Inspektion des Ätzprozesses ein optischer Sensor in Kontakt mit dem transparenten Bereich der Ätzvorrichtung gelangt, das Warnsignal ausgegeben werden, bevor der optische Sensor den transparenten Bereich der Stirnseite zerstört und dadurch Ätzflüssigkeit aus der Ätzvorrichtung austritt.

In einer vorteilhaften Weiterbildung der Erfindung ist die Ätzvorrichtung zweiteilig ausgestaltet, wobei ein Unterteil der Ätzvorrichtung insbesondere den Hohlraum zumindest teilweise und/oder ein Oberteil der Ätzvorrichtung die Arretierung und/oder den Zwischenraum umfassen können. Das Oberteil der Ätzvorrichtung kann dazu ausgestaltet sein, den Hohlraum zu verschließen, wobei in einem verschlossenen Zustand der Ätzvorrichtung das Oberteil die der Arretierung zugewandte Stirnseite mit dem transparenten Bereich umfassen kann. Daneben kann die Arretierung an einer dem Hohlraum zugewandten Seite des Oberteils, insbesondere zwischen dem Hohlraum und dem Zwischenraum angeordnet sein.

Das Unterteil der Ätzvorrichtung kann in konstruktiv einfacher Weise die Auflagefläche, insbesondere den mindestens einen Standfuß, umfassen. Vorzugsweise ist die Ätzvorrichtung, insbesondere das Oberteil und/oder das Unterteil, zylinderförmig ausgestalte, wobei alternativ auch quader-, insbesondere würfelförmige Ausgestaltungen vorgesehen sein können.

Das Oberteil kann als Deckelelement für das Unterteil ausgestaltet sein, mit dem der Hohlraum des Unterteils wahlweise dicht verschlossen oder wieder freigegeben werden kann. Vorzugsweise weist das Oberteil eine zum Unterteil korrespondierende Außenkontur auf, so dass die Außenseite des Oberteils bündig an der Außenseite des Unterteils anliegt, wenn das Unterteil mit dem Oberteil verbunden, insbesondere verschlossen ist. Dies ermöglicht eine einfache Handhabung der erfindungsgemäßen Ätzvorrichtung. Bevorzugt ist eine ätzbeständige Dichtung, die beispielsweise als Dichtungsring ausgestaltet ist, in einem Bereich zwischen dem Oberteil und dem Unterteil vorgesehen. Zum Verschluss des Hohlraums können das Unterteil und das Oberteil an ihren jeweiligen Außenseiten angeordnete und zueinander korrespondierende Verschlusselemente aufweisen, so dass das Unterteil mit dem Oberteil lösbar verbunden, insbesondere kraft- und/oder formschlüssig verbunden werden kann. Bevorzugt ist hierzu mindestens ein Schnellspanner vorgesehen, um das Oberteil mit dem Unterteil zu verklemmen.

Vorzugsweise befindet sich die Arretierung stets in einem vordefinierten Abstand zu der zur Arretierung zugewandten Stirnseite, wobei hierzu insbesondere das Oberteil die mindestens eine Arretierung aufweisen kann.

In einer vorteilhaften Weiterbildung der Erfindung weisen das Oberteil den Zulaufkanal und das Unterteil eine Ätzflüssigkeitszulaufleitung auf, wobei die Ätzflüssigkeitszulaufleitung bei geschlossenem Zustand der Ätzvorrichtung mit dem Zulaufkanal verbunden ist. Der Durchmesser der Ätzflüssigkeitszulaufleitung kann dem Durchmesser des Zulaufkanals, insbesondere in einem zur Ätzflüssigkeitszulaufleitung gerichteten Abschnitt, entsprechen. Dadurch ist es möglich, Ätzflüssigkeit über die Ätzflüssigkeitszulaufleitung und über den Zulaufkanal in den Zwischenraum zu der zu bearbeitenden Oberfläche des Werkstücks zu leiten. Dabei kann die Ätzflüssigkeitszulaufleitung auch dann mit einer Ätzflüssigkeitsquelle verbunden bleiben, wenn das Oberteil in Folge des Austauschs eines Werkstücks vom Unterteil entfernt wird. Im Vergleich zu einer Zufuhr der Ätzflüssigkeit ausschließlich über das Oberteil sind die hierfür erforderlichen, ätzflüssigkeitsführenden Verbindungen nicht von den Bewegungen des Oberteils, etwa beim Öffnen oder Schließen des Hohlraums beeinträchtigt. Die Ätzflüssigkeitszulaufleitung kann zumindest abschnittsweise als Glasrohr ausgestaltet oder mit einem solchen Glasrohr verbunden sein.

Vorzugsweise ist mindestens ein optischer Sensor der Ätzvorrichtung derart angeordnet, dass das in den Hohlraum einbringbare Werkstück zumindest teilweise durch den transparenten Bereich von dem optischen Sensor erfassbar ist, um den Ätzprozess visuell inspizieren zu können. Der optische Sensor kann als optisch vergrößerndes System ausgebildet sein und/oder elektromagnetische Strahlung im Infrarot-, Ultraviolett- und/oder sichtbaren Spektrum verwenden, um das Werkstück zu inspizieren. In einer vorteilhaften Weiterbildung der Erfindung ist der optische Sensor als Mikroskop, insbesondere als Objektiv eines Mikroskops, ausgebildet, das insbesondere in Richtung des Werkstücks verfahrbar sein kann. Daneben kann der optische Sensor eine Kamera, insbesondere eine Videokamera aufweisen, um Bildinformationen des Werkstücks zu speichern und zu bearbeiten. Der optische Sensor kann in einem insbesondere veränderlichen Abstand zu der zur Arretierung weisenden Stirnseite angeordnet sein. Der optische Sensor kann daneben zur Ausgabe eines Warnsignals ausgebildet sein, wenn der optische Sensor einen vordefinierten Abstand zu dem transparenten Bereich der Stirnseite unterschreitet und/der diesen berührt.

Die Ätzflüssigkeitsquelle der erfindungsgemäßen Ätzsystems kann in einfacher Weise als ein dichtend verschließbares Behältnis ausgestaltet sein, das eine ätzbeständige Oberfläche aufweist und zur Lagerung von Ätzflüssigkeiten dient. Vorzugsweise weist das Ätzsystem eine Mehrzahl derartiger Ätzflüssigkeitsquellen auf, die über ein Leitungssystem, das insbesondere mindestens ein Ventil und mindestens eine Zuführleitung aufweisen kann, miteinander verbunden sein können. Das mindestens eine Ventil ist vorzugsweise als Zweiwegeventil ausgebildet.

Das erfindungsgemäße Ätzsystem kann mindestens eine Pumpeinrichtung und/oder mindestens eine Ventileinrichtung aufweisen, die mindestens mittelbar mit der Ätzflüssigkeitszulaufleitung und/oder mit der Ätzflüssigkeitsablaufleitung verbunden ist, um Ätzflüssigkeit mit einer insbesondere vordefinierten Fließgeschwindigkeit zum Zwischenraum zu leiten und/oder von dem Zwischenraum abzuleiten. Mittels der Pumpeinrichtung und/oder der Ventileinrichtung kann der Fluss der Ätzflüssigkeit benutzerdefiniert gesteuert werden, beispielsweise um den Ätzvorgang benutzerdefiniert zu starten und/oder ihn zu beenden.

Die Pumpeinrichtung umfasst mindestens eine Pumpe und ist insbesondere über die Ventileinrichtung mit der mindestens einen Ätzflüssigkeitsquelle sowie mit dem Zulaufkanal und mit der Ätzflüssigkeitszulaufleitung verbunden, um Ätzflüssigkeit von der Ätzflüssigkeitsquelle über die Ätzflüssigkeitszulaufleitung und den Zulaufkanal in den Zwischenraum zu fördern. Daneben kann die Pumpeinrichtung mit dem Zulaufkanal, der Ablaufleitung und dem Ätzflüssigkeitsreservoir verbunden sein, um die Ätzflüssigkeit nach dem Ätzprozess benutzerdefiniert aus dem Zwischenraum zum Ätzflüssigkeitsreservoir zu leiten. Die Pumpeinrichtung ist insbesondere elektrisch steuerbar ausgestaltet und kann die Einstellung eines volumen- und/oder druckgeregelten Ätzflüssigkeitsstroms erlauben.

Die Ventileinrichtung umfasst mindestens ein steuerbares Ventil, insbesondere ein Magnetventil, das als Sperr-, Wege oder Mischventil ausgestaltet sein kann. Das mindestens eine steuerbare Ventil ist vorzugsweise als Zweiwegeventil ausgebildet. Die Ventileinrichtung kann elektrisch ansteuerbar sein. Durch die Ventileinrichtung kann der Ätzflüssigkeitsstrom auf einfache Weise mittels eines elektrischen Signals insbesondere benutzerdefiniert freigegeben oder gesperrt werden, um den Ätzprozess der Ätzvorrichtung zu beginnen, zu unterbrechen und/oder zu beenden.

In einer vorteilhaften Weiterbildung der Erfindung ist die Ventileinrichtung und/oder die Pumpeinrichtung mit mehreren Ätzflüssigkeitsquellen verbunden, um die Ätzflüssigkeit in einem benutzerdefinierten Mischungsverhältnis in den Zwischenraum zu fördern. Hierfür kann mindestens ein Mischventil vorgesehen sein. Daneben kann eine Spülflüssigkeitsquelle vorgesehen sein, um eine in der Spülflüssigkeitsquelle befindliche Spülflüssigkeit, insbesondere mittels der Pumpeinrichtung und/oder der Ventileinrichtung, benutzerdefiniert in den Zwischenraum zu leiten, um den Ätzprozess zu unterbrechen und die Ätzflüssigkeit kontrolliert aus dem Zwischenraum zu fördern.

Vorzugsweise ist die Pumpeinrichtung und/oder die Ventileinrichtung mit einer Steuereinheit derart verbunden, dass die Ätzflüssigkeit mit einem benutzerdefinierten Prozessparameter in die Ätzvorrichtung einbringbar ist, wobei der Prozessparameter mindestens ein Parameter der folgenden Gruppe umfasst: Zusammensetzung der Ätzflüssigkeit, Fließgeschwindigkeit der Ätzflüssigkeit, Dichte der Ätzflüssigkeit, Zeitpunkt des Zulaufs der Ätzflüssigkeit in den Zwischenraum, Zeitpunkt des Abflusses der Ätzflüssigkeit aus dem Zwischenraum.

Die Steuereinheit kann dazu ausgestaltet sein, die Pumpeinrichtung und/oder die Ventileinrichtung mit einer vorgegebenen Taktfrequenz zu steuern. Vorzugsweise ist die Zusammensetzung der zum Zwischenraum geleiteten Ätzflüssigkeit mittels der Steuereinheit benutzerdefiniert steuerbar, insbesondere mittels der genannten Mischventile. Daneben kann die Steuereinheit mit dem elektrischen Anschluss und/oder mit dem Heizelement verbunden sein, um den elektrischen und/oder den thermischen Ätzprozess zu steuern.

Eine vorteilhafte Weiterbildung der Erfindung kann vorsehen, dass das Heizelement als Teil des Ätzsystems außerhalb der Ätzvorrichtung derart angeordnet ist, dass die Ätzflüssigkeit temperiert wird, bevor und/oder während sie in die Ätzflüssigkeitszulaufleitung und/oder in den Zulaufkanal tritt.

Die Ätzvorrichtung und/oder zumindest eine Komponente des Ätzsystems können in einer Auffangwanne angeordnet sein, um die Umgebung vor gegebenenfalls austretender Ätzflüssigkeit im Falle einer Leckage zu schützen.

Weitere Vorteile und Merkmale der Erfindung ergeben sich aus den Ansprüchen und der nachfolgenden Beschreibung, in der Ausführungsbeispiele der Erfindung im Einzelnen erläutert sind. Dabei zeigen:
- Fig. 1: ein erstes Ausführungsbeispiel einer erfindungsgemäßen Ätzvorrichtung in einer Frontansicht, wobei ein Unterteil und ein Oberteil der Ätzvorrichtung voneinander gelöst dargestellt sind;
- Fig. 2: die Ätzvorrichtung gemäß Fig. 1 mit zusammengesetztem Unterteil und Oberteil;
- Fig. 3: die Ätzvorrichtung gemäß Fig. 1 in einem Schnitt;
- Fig. 4: die Ätzvorrichtung gemäß Fig. 2 in einem Schnitt;
- Fig. 5: das Oberteil der Ätzvorrichtung gemäß Fig. 1 einer Aufsicht;
- Fig. 6: das Oberteil gemäß Fig. 5 in einer Unteransicht;
- Fig. 7: das Unterteil der Ätzvorrichtung gemäß Fig. 1 in einer Aufsicht;
- Fig. 8: eine Werkstückaufnahme der Ätzvorrichtung gemäß Fig. 1 in a) einer Frontansicht und b) einer Aufsicht;
- Fig. 9: ein zweites Ausführungsbeispiel einer erfindungsgemäßen Ätzvorrichtung mit einem optischen Sensor in einer geschnittenen Frontansicht;
- Fig. 10: ein drittes Ausführungsbeispiel einer erfindungsgemäßen Ätzvorrichtung zum elektrolytischen Ätzen;
- Fig. 11: ein viertes Ausführungsbeispiel einer erfindungsgemäßen Ätzvorrichtung zum thermischen Ätzen;
- Fig. 12: einen Teil eines Ätzsystems in Seitenansicht;
- Fig. 13: der Teil des Ätzsystems gemäß Fig. 12 in einem Schnitt;
- Fig. 14: der Teil des Ätzsystems gemäß Fig. 12 in Aufsicht;
- Fig. 15: der Teil des Ätzsystems gemäß Fig. 12 in Hinteransicht;
- Fig. 16: ein viertes Ausführungsbeispiel der erfindungsgemäßen Ätzvorrichtung in einer Seitenansicht;
- Fig. 17: die Ätzvorrichtung gemäß Fig. 16 in einem Schnitt und
- Fig. 18: das Ätzsystem gemäß Fig. 13 bis 15, das einen Ätzmittelkreislauf aufweist.

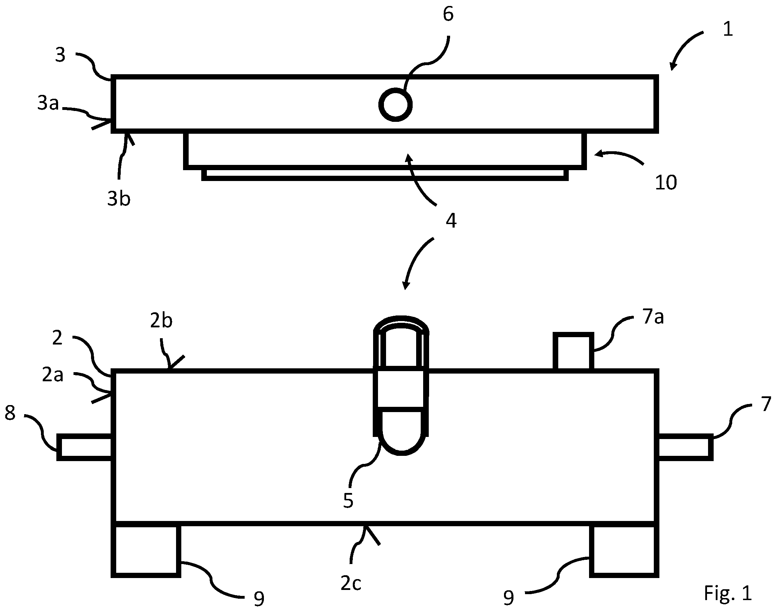

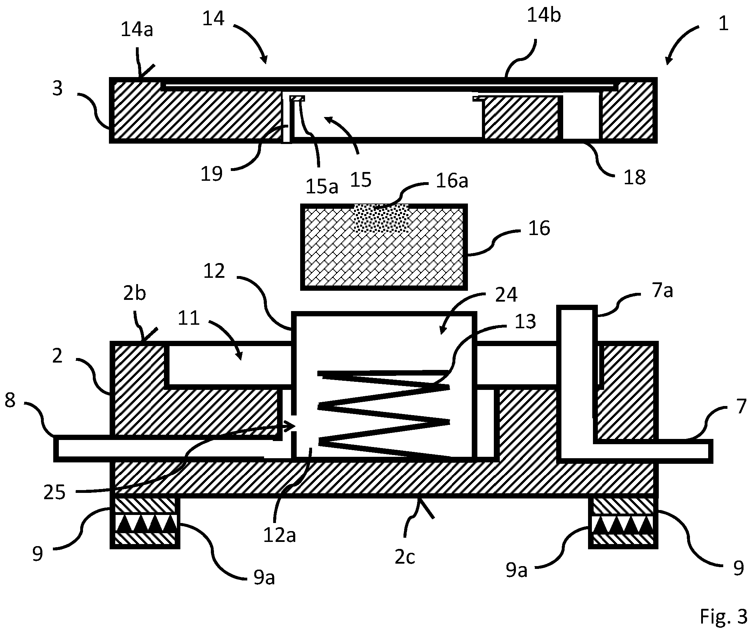

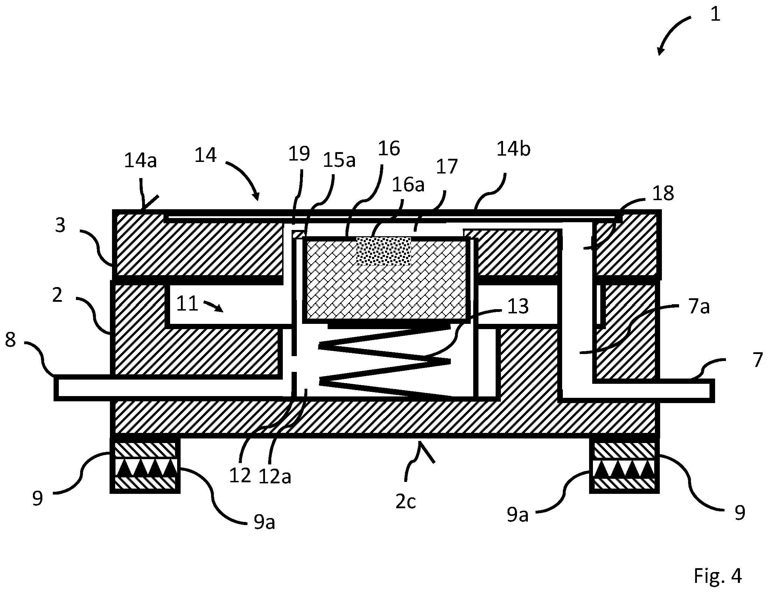

Fig. 1 zeigt ein erstes Ausführungsbeispiel einer erfindungsgemäßen Ätzvorrichtung 1, die zur chemischen Bearbeitung eines Werkstückes 16 mittels einer Ätzflüssigkeit dient. Die Ätzvorrichtung 1 ist zweiteilig und näherungsweise zylinderförmig ausgebildet und umfasst ein Unterteil 2 und ein Oberteil 3, wobei das Oberteil 3 dazu ausgestaltet ist, einen in dem Unterteil 2 ausgebildeten Hohlraum 11 (siehe Fig. 3 und 4) zu verschließen. Die Ätzvorrichtung 1 weist einen Schnellspannverschluss 4 auf, der einen Spannbügel 5 und einen dazu korrespondierenden Vorsprung 6 umfasst. Der Spannbügel 5 ist an der radialen Mantelfläche 2a des Unterteils 2 angeordnet, während der Vorsprung 6 an der radialen Mantelfläche 3a des Oberteils 3 angeordnet ist.

Das Unterteil 2 weist eine Ätzflüssigkeitszulaufleitung 7 und eine Ätzflüssigkeitsablaufleitung 8 auf. Die Ätzflüssigkeitszulaufleitung 7 verläuft radial durch die Mantelfläche 2a des Unterteils 2 und mündet in ein vertikal ausgerichtetes Glasrohr 7a, das den Hohlraum 11 durchgreift, einer oberen Stirnseite 2b des Unterteils 2 übersteht und gemäß Fig. 1 zum Oberteil 3 gerichtet ist. Die Ätzmittelablaufleitung 8 verläuft ebenfalls durch die Mantelfläche 2a des Unterteils 2 und mündet in dessen Hohlraum 11. Auf einer dem Oberteil 3 abgewandten Unterseite 2c des Unterteils 2 sind Standfüße 9 mit Auflageflächen vorgesehen.

Das Oberteil 3 weist auf der dem Unterteil 2 zugewandten Unterseite 3b eine Zentrierung 10 auf, mittels derer das Oberteil 3 radial zentriert auf dem Unterteil 2 positioniert und unter enger Passung in dieses eingesetzt werden kann. Die Zentrierung 10 weist hierfür einen geringfügig kleineren Durchmesser als der Innendurchmesser des Hohlraums 11 auf. Die Zentrierung 10 weist in einer in Fig. 1 nicht gezeigten Weise eine radial seitlich angeordnete, chemisch und korrosiv beständige Dichtung auf. Zur besseren Übersichtlichkeit ist die Zentrierung 10 in den nachfolgenden Fig. nicht mehr gezeigt.

Die in Fig. 1 gezeigte Ätzvorrichtung 1 befindet sich in einem Beschickungszustand, in dem ein Werkstück 16 innerhalb des Unterteils 2 auf einer Schraubenfeder 13 in einer zylinderförmigen, ätzbeständigen Werkstückaufnahme 12 des Unterteils 2 positioniert werden kann. Dieser Zustand ist in Bezug auf Fig. 3 erläutert.

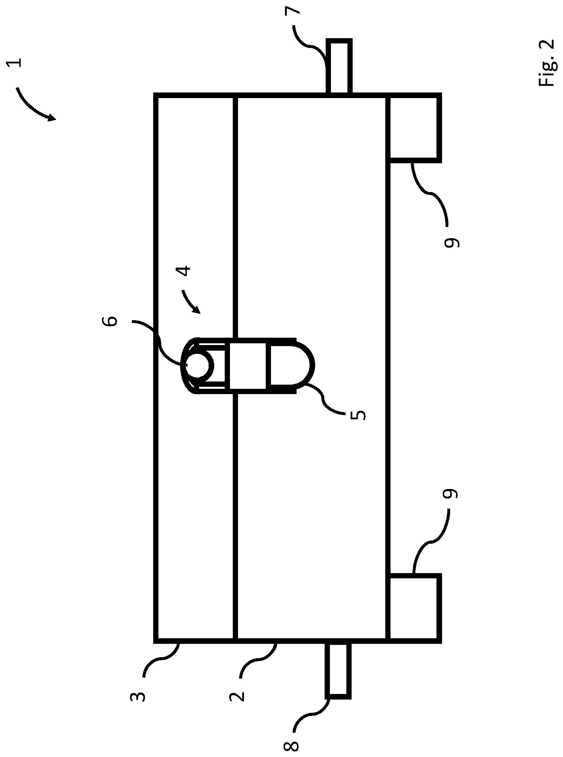

Fig. 2 zeigt die Ätzvorrichtung 1 gemäß Fig. 1 mit dem Unterteil 2 und dem Oberteil 3 in einem zusammengesetzten Zustand, wobei der Spannbügel 5 und der Vorsprung 6 miteinander verspannt sind. Gemäß Fig. 2 befindet sich die Ätzvorrichtung 1 in einem Betriebszustand, welcher in Bezug auf Fig. 4 erläutert ist.

Fig. 3 zeigt die Ätzvorrichtung 1 gemäß Fig. 1, also im Beschickungszustand, in einem Schnitt. Entsprechend der Darstellung in Fig. 1 ist das Oberteil 3 von dem Unterteil 2 gelöst und angehoben dargestellt. Das Unterteil 2 weist den Hohlraum 11 an der oberen Stirnseite 2b auf. In dem Hohlraum 11 ist wie bereits gesagt die Werkstückaufnahme 12 angeordnet, die in dem hier gezeigten Ausführungsbeispiel hohl ausgestaltet ist und auf einer zu dem Oberteil 3 gewandten Seite eine Öffnung 24 auf ihrer oberen Stirnseite aufweist, um das Werkstück 16 aufzunehmen.

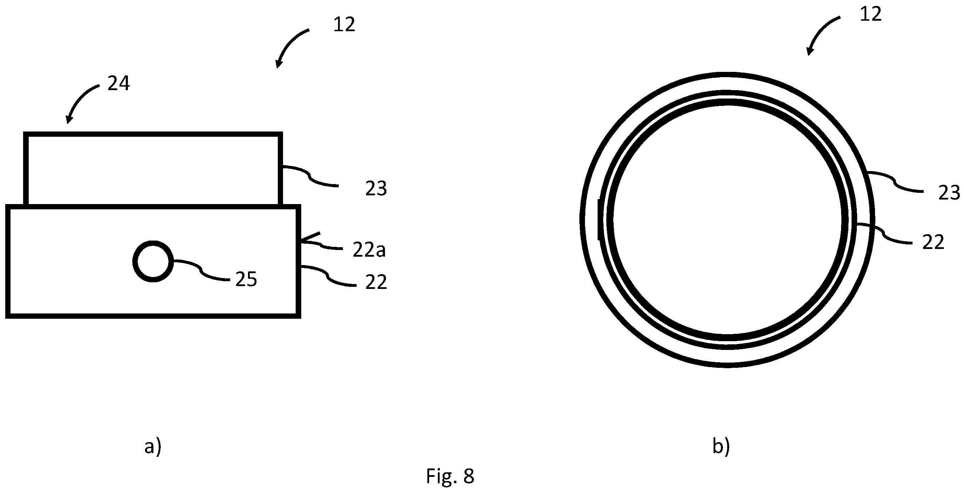

Innerhalb der Werkstückaufnahme 12 ist ein Klemmelement in Gestalt einer metallischen Schraubenfeder 13 angeordnet, auf die das Werkstück 16 positionierbar ist. An einem dem Oberteil 3 abgewandten Ende ist die Schraubenfeder 13 mit der Werkstückaufnahme 12 starr verbunden. Die Werkstückaufnahme 12 ist in Fig. 8 im Detail gezeigt und wird weiter unten im Einzelnen beschrieben.

Das Oberteil 3 weist an seiner axial oberen Stirnseite 14a einen transparenten Bereich 14 auf, der hier als optisches Glas 14b ausgebildet ist, das als Einsatzteil bündig an der Stirnseite 14a des Oberteils 3 angeordnet ist und auf dem Oberteil 3 auf einem Bereich aufliegt, der insofern als Auflagefläche dient. An dem Oberteil 3 ist eine hier ringförmige Arretierung 15 ausgebildet. Bei geöffnetem Hohlraum 11 - die Ätzvorrichtung 1 befindet sich im Beschickungszustand - wird ein zu ätzendes Werkstück 16 mit einer zu ätzenden und zu untersuchenden Werkstückprobe 16a in die Werkstückaufnahme 12 und auf der Schraubenfeder 13 positioniert. Anschließend wird das Oberteil 3 auf das Unterteil 2 aufgesetzt und mit diesem verspannt, um den Hohlraum 11 zu verschließen. Hierbei gelangt die Arretierung 15 mit einem Randbereich des Werkstücks 16 in mechanischen Kontakt. Die Verschlussbewegung des Oberteils 3 wird mittels der Arretierung 15 auf das Werkstück 16 und auf die Schraubenfeder 13 übertragen, wodurch diese mechanisch gespannt wird und als Klemmelement dient. Bei verschlossenem Hohlraum 11 - die Ätzvorrichtung 1 befindet sich im Betriebszustand - ist das Werkstück 16 somit zwischen der Schraubenfeder 13 und der Arretierung 15 eingeklemmt und mit einer axial nach oben, zur Arretierung 15 gerichteten Kraft beaufschlagt. Dies ist in Fig. 4 gezeigt.

Der Arretierung 15 ist als ringförmig umlaufender radialer Vorsprung 15a ausgebildet; bei verschlossenem Hohlraum 11 ist axial zwischen dem transparenten Bereich 14 des Oberteils 3 und der Oberfläche des Werkstücks 16 ein Zwischenraum 17 ausgebildet, wobei der Vorsprung 15 zwischen dem Hohlraum 11 und dem Zwischenraum 17 angeordnet sowie die Oberfläche des Werkstückes 16 parallel zu der Stirnseite 14a, insbesondere parallel zur Oberfläche des eingesetzten Glases 14b ausgerichtet ist. Dies ist vorteilhaft, da die Oberfläche des Werkstückes 16, insbesondere die Oberfläche der zu untersuchenden Werkstückprobe 16a, durch den transparenten Bereich 14 gleichmäßig gut erkennbar sind und ein Mikroskop als optischer Sensor 26 verwendet werden kann, um das Werkstück 16 während des Ätzprozesses zu überwachen. Durch das Klemmelement 13, das als Schraubenfeder 13 ausgebildet ist, befindet sich die zu bearbeitende Werkstückoberfläche stets in einem konstruktiv vordefinierten - axialen - Abstand zum Glas 14b. Dies ermöglicht eine zuverlässige Inspektion des Werkstücks 16 auch in situ während des Ätzprozesses. Die optische Achse des optischen Sensors 26 entspricht dabei der axialen Richtung.

Die Ätzflüssigkeitszulaufleitung 7 mündet gemäß Fig. 4 im geschlossenen Zustand der Ätzvorrichtung 1, also insbesondere bei dem durch das Oberteil 3 verschlossenem Hohlraum 11, über das Glasrohr 7a in einen Zulaufkanal 18 des Oberteils 3. Der Durchmesser der Ätzflüssigkeitszulaufleitung 7 sowie der Durchmesser des Glasrohrs 7a entsprechen jeweils dem Durchmesser des zu dieser gerichteten Abschnitts des Zulaufkanals 18. Der Zulaufkanal 18 erstreckt sich durch das Oberteil 3 und mündet in den Zwischenraum 17. Dadurch gelangt die Ätzflüssigkeit auf die zu ätzende Oberfläche des Werkstücks 16. Über einen Ablaufkanal 19 kann die Ätzflüssigkeit zusammen mit den gelösten Bestandteilen des Werkstückes 16 aus dem Zwischenraum 17 in den Hohlraum 11 und über die Ätzflüssigkeitsablaufleitung 8 des Unterteils 2 aus der Ätzvorrichtung 1 geleitet werden.

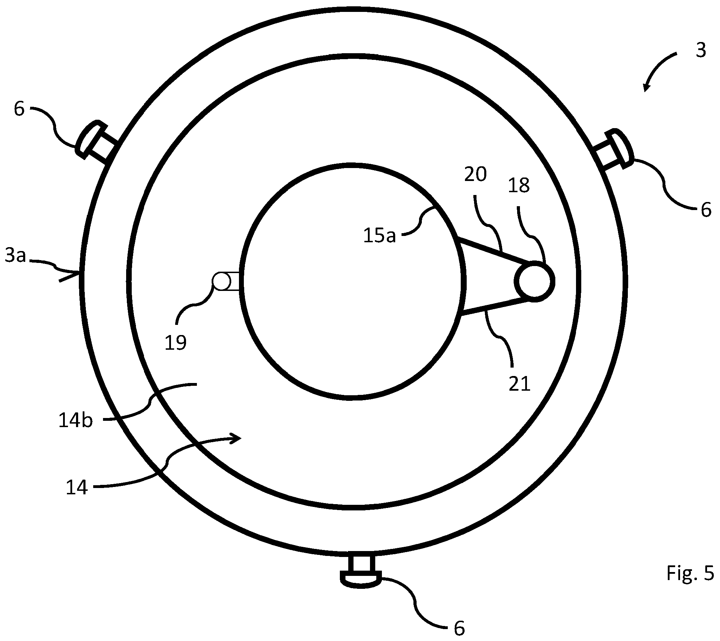

Fig. 5 zeigt das Oberteil 3 in einer Aufsicht, in der erkennbar ist, dass das Oberteil 3 eine im Wesentlichen kreisrunde Außenkontur aufweist, an deren radial äußerer Mantelfläche 3a insgesamt drei Vorsprünge 6 über den Umfang gleichverteilt angeordnet sind. Der transparente Bereich 14 weist ebenfalls eine im Wesentlichen kreisrunde Außenkontur auf und ist - als optisches Glas 14b - in bereits erläuterter Weise in das Oberteil 3 eingesetzt. Aufgrund der Transparenz des optischen Glases 14b, das den transparenten Bereich 14 ausbildet, ist in der Aufsicht der Fig. 5 der Zulaufkanal 18 ersichtlich, der axial unterhalb des transparenten Bereichs 14 ausgebildet ist. Der Zulaufkanal 18 weist einen Abschnitt auf, welcher im Wesentlichen axial unterhalb des optischen Glases 14b verläuft und durch zwei Wände 20, 21 seitlich begrenzt ist. In diesem Abschnitt ist der Zulaufkanal 18 als 1 mm tiefe Nut ausgestaltet, die von den Wänden 20, 21 umgeben ist. Die Wände 20, 21 weisen einen sich in Richtung des Zwischenraums 17 zunehmenden Abstand zueinander auf und schließen dadurch zwischen sich einen spitzen Winkel ein, so dass der Zulaufkanal 18 in Richtung des Zwischenraums 17 verbreiternd ausgestaltet ist. Dadurch werden die Strömungseigenschaften der durch den Zulaufkanal 18 zum Werkstück 16 fließenden Ätzflüssigkeit verbessert und insbesondere die Bildung von Luftblasen in dem Zwischenraum 17 vermeiden. Der Ablaufkanal 19 des Oberteils 3 ist ebenfalls in Fig. 5 ersichtlich und weist in dem in Fig. 5 ersichtlichen Bereich einen konstanten Durchmesser auf, der kleiner als der Durchmesser des Zulaufkanals 18 ist.

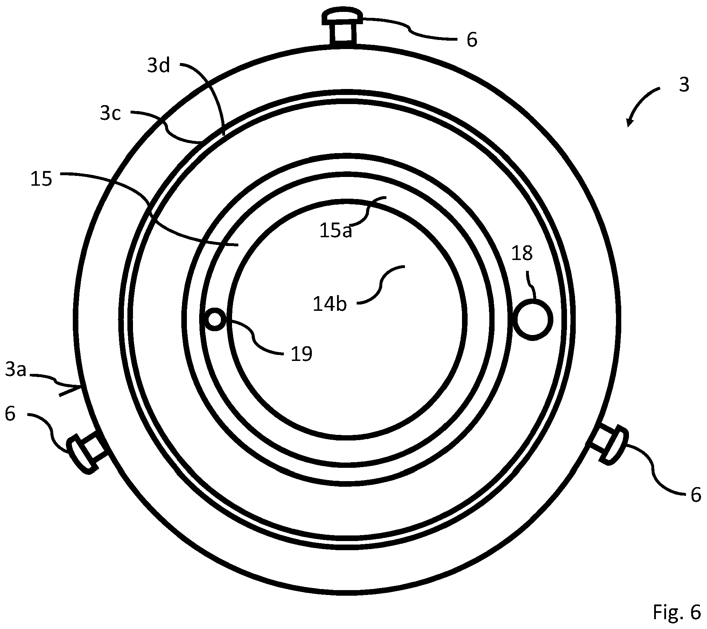

Fig. 6 zeigt das Oberteil 3 der Fig. 5 in einer Unteransicht. Der Zulaufkanal 18 ist derart angeordnet, um bei verschlossenem Hohlraum 11 des Unterteils 2 mit dem Glasrohr 7a und mit der Ätzflüssigkeitszulaufleitung 7 des Unterteils 2 zu kommunizieren. Der Ablaufkanal 19 mündet in den durch das Oberteil 3 verschlossenen Hohlraum 11 des Unterteils 2. In Fig. 6 ist lediglich der Teil des optischen Glases 14b zu sehen, der von dem ringförmigen Vorsprung 15a der Arretierung 15 umrandet ist. Die Unterseite des Oberteils 3 der Fig. 6 weist radial in etwa mittig zwischen der Arretierung 15 und der Mantelfläche 3a eine Ringnut 3c auf, in die ein Dichtungsring 3d eingesetzt ist, um den Hohlraum 11 des Unterteils 2 bei zusammengesetzter Ätzvorrichtung 1 nach außen abzudichten.

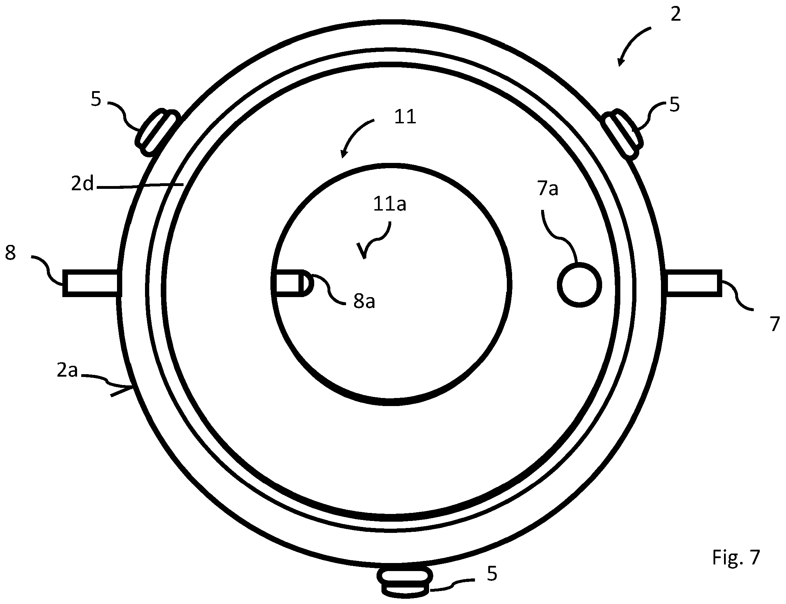

Fig. 7 zeigt das Unterteil 2 der Ätzvorrichtung 1, das die zu dem Oberteil 3 korrespondierende, zylinderförmige Mantelfläche 2a aufweist, an der drei Spannbügel 5 über den Umfang gleichverteilt angeordnet sind. Die Spannbügel 5 sind zu den Vorsprüngen 6 des Oberteils 3 korrespondierend ausgebildet. In der Aufsicht der Fig. 7 ist der Hohlraum 11 des Unterteils 2 freigegeben. In bereits erläuterter Weise dient die Ätzflüssigkeitszulaufleitung 7 dazu, Ätzflüssigkeit in den Zulaufkanal 18 des Oberteils 3 zu fördern. Die Ätzflüssigkeitsablaufleitung 8 dient dazu, die aus dem Ablaufkanal 18 des Oberteils 3 austretende Ätzflüssigkeit aus dem Hohlraum 11 des Unterteils 2 zu führen. Wie anhand von Fig. 7 erkennbar ist, ist der Ätzmittelablaufkanal 8 teilweise als Nut 8a ausgebildet, die in einen Boden 11a des Hohlraums 11 eingeformt ist und durch die Mantelfläche 2a des Unterteils 2 verläuft. Die Oberseite des Unterteils 2 gemäß Fig. 7 weist eine Ringnut 2d auf, die korrespondierend zur Ringnut 3c des Oberteils 3, mithin ebenfalls zur Aufnahme des Dichtungsrings 3d bei verschlossener Ätzvorrichtung 1 ausgestaltet ist.

In einer alternativen Ausgestaltung der Ätzvorrichtung 1 kann der Ablaufkanal 19 des Oberteils 3 unmittelbar in die Ätzmittelablaufleitung 8 des Unterteils 2 münden, wobei die Ätzmittelablaufleitung 8 analog zu der Ätzmittelzulaufleitung 7 teilweise ein Glas- oder Kunststoffrohr aufweisen kann oder mit einem Glas- oder Kunststoffrohr verbunden sein kann.

Fig. 8 zeigt in Ansicht a) eine Frontansicht und in Ansicht b) eine Aufsicht auf die Werkstückaufnahme 12. Die Werkstückaufnahme 12 weist eine abgestufte Hohlzylinderform mit einem unteren Zylinderteil 22 und einem oberen Zylinderteil 23 auf, wobei das obere Zylinderteil 23 einen geringeren Durchmesser als das untere Zylinderteil 22 aufweist. Beide Zylinderteile 22 und 23 sind als Hülsen ausgestaltet und begrenzen den Innenraum 12a, der in Fig. 3 gezeigt ist und in dem das bereits beschriebene Klemmelement in Gestalt der Schraubenfeder 13 angeordnet werden kann. Das obere Zylinderteil 23 weist stirnseitig die Öffnung 24 auf, durch die das Werkstück 16 eingeführt und auf die in der Werkstückaufnahme 12 positionierte Schraubenfeder 13 aufgelegt werden kann. Die Zylinderteile 22, 23 sind aus Polytetrafluorethylen (PTFE) hergestellt.

Das untere Zylinderteil 22 weist an seiner Mantelfläche 22a eine Öffnung 25 auf, die den Innenraum 12a der Werkstückaufnahme 12 freigibt. Die aus dem Ablaufkanal 19 in den Hohlraum 11 des Unterteils 2 geleitete Ätzflüssigkeit kann über die Öffnung 25 in den Innenraum 12a der Werkstückaufnahme 12 gelangen und kann durch die Öffnung 25 aus der Werkstückaufnahme 12 wieder abfließen. Der Innenraum 12a der Werkstückaufnahme 12 ist somit nicht gegenüber dem Hohlraum 11 des Unterteils 2 abgedichtet.

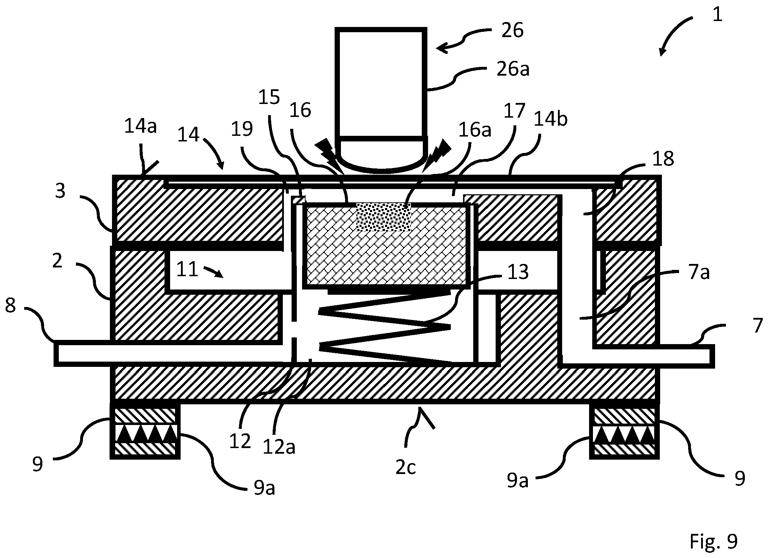

Fig. 9 zeigt ein zweites Ausführungsbeispiel der erfindungsgemäßen Ätzvorrichtung 1, die in ihrem Aufbau im Wesentlichen identisch zum ersten Ausführungsbeispiel der Ätzvorrichtung 1 ist und entsprechend identisch aufgebaute Komponenten aufweist (vgl. Fig. 1 bis 8). Für die gleichen technischen Komponenten werden in Fig. 9 die gleichen Bezugszeichen wie in den Fig. 1 bis 8 verwendet und auf die entsprechenden Ausführungen verwiesen.

Die Ätzvorrichtung 1 gemäß Fig. 9 weist zur visuellen Inspektion eines Ätzvorgangs einen axial oberhalb des Glases 14b angeordneten optischen Sensor 26 auf, der im gezeigten Ausführungsbeispiel als schematisch dargestelltes Mikroskop 26 ausgestaltet ist, wobei Fig. 9 ein axial verfahrbares Objektiv 26a des Mikroskops 26 zeigt, um den Ätzprozess, insbesondere in situ, visuell zu inspizieren. Bei der axialen Bewegung des Objektivs 26a besteht die Gefahr, dass das Objektiv 26a in Kontakt mit dem Glas 14b gelangt und dieses, bei fortgesetzter Bewegung, bricht, was insbesondere aufgrund der dann austretenden Ätzflüssigkeit gravierende Schäden verursachen würde. Zur Vermeidung einer Beschädigung der Ätzvorrichtung 1 weisen deren Stellfüße 9 jeweils einen Drucksensor 9a auf. Die Drucksensoren 9a sind dazu ausgestaltet, einen gegen den Untergrund gerichtete Kraft zu bestimmen. Diese Kraft entspricht im Normalbetrieb der Gewichtskraft der Ätzvorrichtung 1. Gelangt jedoch das Objektiv 26a in Kontakt mit dem Glas 14b, erhöht sich die von den Drucksensoren 9a bestimmte Kraft. In diesem Fall ist vorgesehen, dass ein Warnsignal ausgegeben wird, um einen Benutzer auf eine bevorstehende Beschädigung der Ätzvorrichtung 1 hinzuweisen.

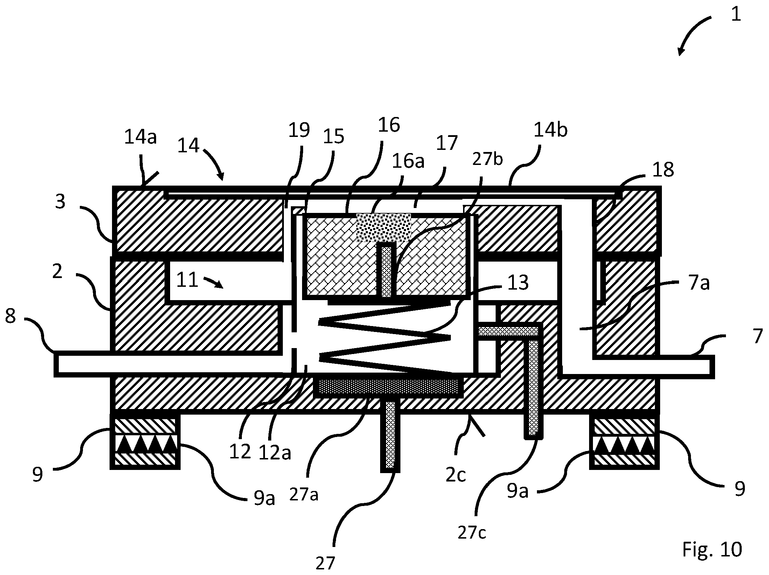

Fig. 10 zeigt die erfindungsgemäße Ätzvorrichtung 1 in einem dritten Ausführungsbeispiel, das ähnlich zu der Ausgestaltung gemäß Fig. 9 ist und entsprechend teilweise identisch aufgebaute Komponenten aufweist. Daher werden für die gleichen technischen Komponenten in Fig. 10 die gleichen Bezugszeichen wie in Fig. 9 verwendet und auf entsprechende Ausführungen verwiesen. Im Unterschied zur Ausgestaltung der Fig. 9 ist die Schraubenfeder 13 elektrisch leitfähig ausgestaltet und mit elektrisch leitenden Metallplatte 27a des Unterteils 2 kontaktiert. Die Schraubenfeder 13 weist an ihrer zu dem Werkstück 16 weisenden Seite einen elektrischen Kontakt 27b auf, der in Anlage mit dem Werkstück 16 steht und dazu dient, das Werkstück 16 elektrisch zu kontaktieren. Die Werkstückaufnahme 12 ist ebenfalls elektrisch leitend ausgestaltet und kann über einen zweiten Anschluss 27c ebenfalls elektrisch kontaktiert werden, sodass das zu ätzende Werkstück 16 mit einer elektrischen Spannung beaufschlagt werden kann. Hierdurch eignet sich die Ätzvorrichtung der Fig. 10 zum elektrolytischen Ätzen des Werkstückes 16.

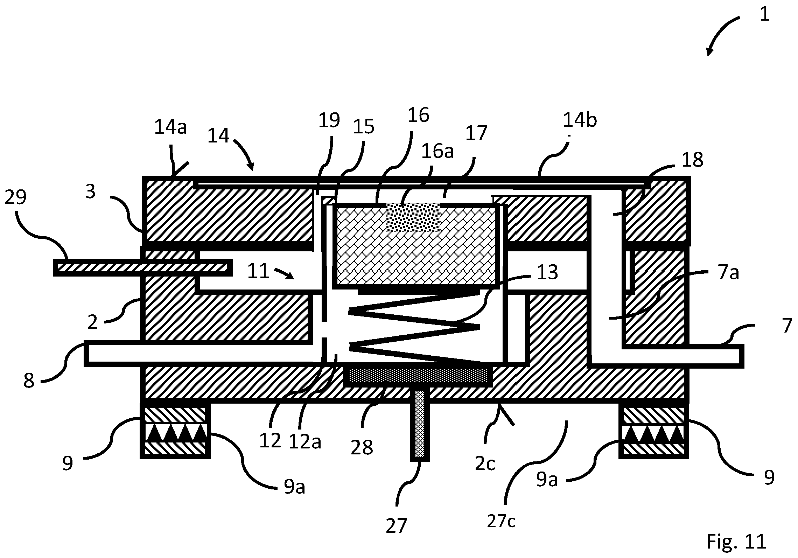

Fig. 11 zeigt ein viertes Ausführungsbeispiel der erfindungsgemäßen Ätzvorrichtung 1, die in ihrem Aufbau ähnlich zu der Ausgestaltung der Fig. 10 ist und entsprechend teilweise identisch aufgebaute Komponenten aufweist. Daher werden für die gleichen technischen Komponenten in Fig. 11 die gleichen Bezugszeichen wie in Fig. 10 verwendet und auf entsprechende Ausführungen verwiesen. Im Unterschied zu der in Fig. 10 gezeigten Ätzvorrichtung 1 weist die Ätzvorrichtung 1 der Fig. 11 eine an dem Unterteil 2 und innerhalb der Werkstückaufnahme 12 angeordnete, elektrische Heizplatte 28 als Heizelement auf sowie einen Temperatursensor 29, der radial das Unterteil 2 auf axialer Höhe der Werkstücks 16 durchgreift und in den Hohlraum 11 ragt. Die Heizplatte 28 wandelt zugeführte elektrische Energie in Wärme um und ist mit dem elektrischen Anschluss 27 des Unterteils 2 elektrisch verbunden. In dem hier gezeigten Ausführungsbeispiel ist die Heizplatte 28 über das Federelement 13 und das Werkstück 16 thermisch leitend mit der Ätzflüssigkeit in dem Zwischenraum 17 verbunden, um die Ätzflüssigkeit benutzerdefiniert zu temperieren und deren Temperatur zu regeln.

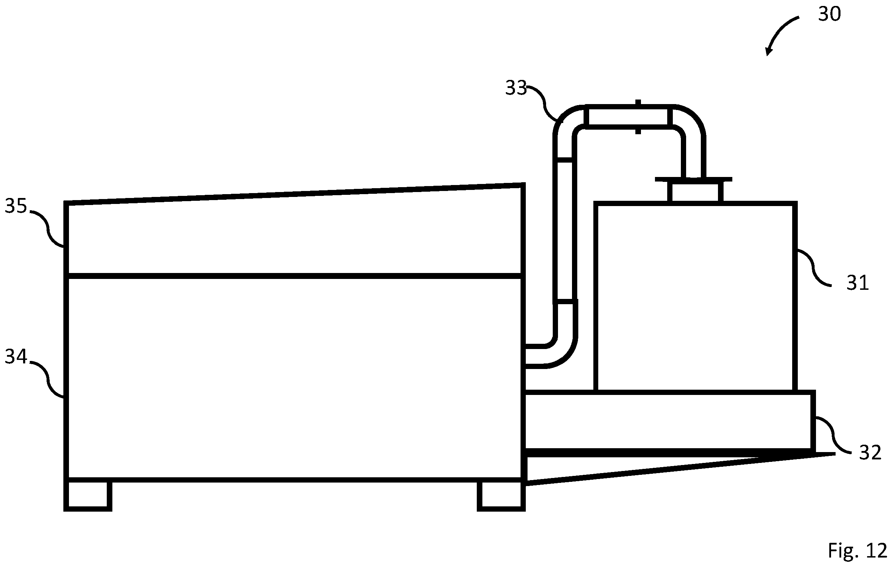

Fig. 12 zeigt einen Teil eines erfindungsgemäßen Ätzsystems 30, das neben der in Fig. 12 nicht gezeigten Ätzvorrichtung 1 und einem in Fig. 12 nicht gezeigten Ätzflüssigkeitsreservoir 48 vier Ätzflüssigkeitsquellen 31 aufweist, von denen in Fig. 12 perspektivisch bedingt nur eine Ätzflüssigkeitsquelle 31 ersichtlich ist. Die Ätzflüssigkeitsquellen 31 sind innerhalb einer Wanne 32 angeordnet, so dass bei einer Leckage aus den Ätzflüssigkeitsquellen 31 austretende Ätzflüssigkeit in der Wanne 32 gesammelt wird und weitere Schäden der Umgebung vermieden werden.

Die Ätzflüssigkeitsquellen 31 sind jeweils über eine Ätzflüssigkeitsleitung 33 mit einem Gehäuse 34 verbunden, in dem eine Pumpeinrichtung 38 und eine Ventileinrichtung 39 angeordnet sind, wobei die Pumpeinrichtung 38 und die Ventileinrichtung 39 in Fig. 12 nicht gezeigt sind. Das Gehäuse 34 umfasst ferner eine ebenfalls in Fig. 12 nicht sichtbare Steuereinheit 37, mit der die Pumpeinrichtung 38 und die Ventileinrichtung 39 steuerbar sind, um Ätzflüssigkeit aus der Ätzflüssigkeitsquelle 31 zu der Ätzvorrichtung 1 zu fördern. Das Gehäuse 34 umfasst einen Deckel 35, in dem eine als Bedienpanel ausgestaltete und in Fig. 12 nicht gezeigte Eingabeeinheit 36 integriert ist. Die Eingabeeinheit 36 ist signaltechnisch mit der Steuereinheit 37 verbunden und erlaubt es, die in dem Gehäuse 34 angeordneten Komponenten zum Betrieb der Ätzvorrichtung 1 zu steuern.

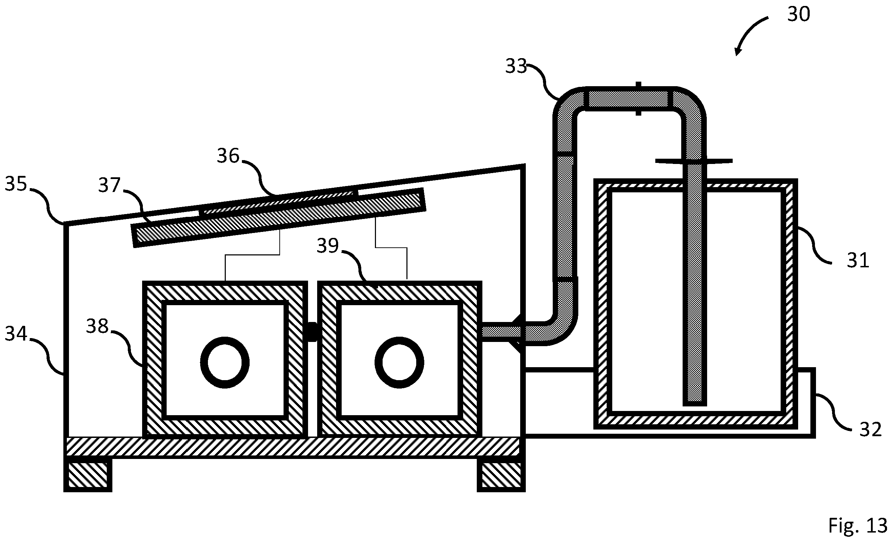

Fig. 13 zeigt den in Fig. 12 gezeigten Teil des Ätzsystems 30 in einem schematischen Schnitt, gemäß dem die in dem Gehäuse 34 angeordnete Pumpeinrichtung 38 und die Ventileinrichtung 39 ersichtlich sind. In dem hier gezeigten Ausführungsbeispiel handelt es sich bei der Ventileinrichtung 39 um ein Wegeventil, mittels dessen Ätzflüssigkeit aus mindestens einer der vier Ätzflüssigkeitsquellen 31 zu der Pumpeinrichtung 38 geleitet wird. Das Bedienpanel 36 ist auf einer dem Gehäuse abgewandten Seite des Deckels 35 angeordnet und mit der Steuereinheit 37 verbunden, die einen Mikrocontroller aufweist. Über die signaltechnischen Verbindungen zwischen der Steuereinheit 37 und der Pumpeinrichtung 38 sowie der Ventileinrichtung 39 ist es möglich, diese zu steuern. Die Steuerung kann zeitgesteuert erfolgen, sodass der Ätzprozess zu benutzerdefinierten Zeitpunkten begonnen und beendet werden kann. Die Pumpeinrichtung 38 ist mit der Ätzmittelzulaufleitung 7 der erfindungsgemäßen Ätzvorrichtung 1 verbunden, was in Fig. 13 nicht dargestellt ist.

In einer alternativen Ausführungsform ist die Ventileinrichtung 39 als Mischventil ausgestaltet, mit dem es möglich ist, die in den Ätzflüssigkeitsquellen 31 befindlichen Ätzflüssigkeiten in einem definierbaren Verhältnis zur Ätzvorrichtung 1, insbesondere in deren Zwischenraum 17 zu fördern. Das Mischverhältnis lässt sich über das Bedienpanel 36 einstellen. Ebenfalls lässt sich über das Bedienpanel 36 ein zeitlicher Ablauf für den Ätzvorgang einstellen. Eine der Ätzflüssigkeitsquellen 31 kann mit einer Spülflüssigkeit gefüllt sein, die benutzerdefiniert über die Steuereinheit 37 derart ansteuerbar ist, dass der Ätzvorgang insbesondere benutzerdefiniert durch ein Zuleiten der Spülflüssigkeit in den Zwischenraum 17 der Ätzvorrichtung 1 gefördert wird. Auf diesem Weg kann der Ätzvorgang kontrolliert beendet werden.

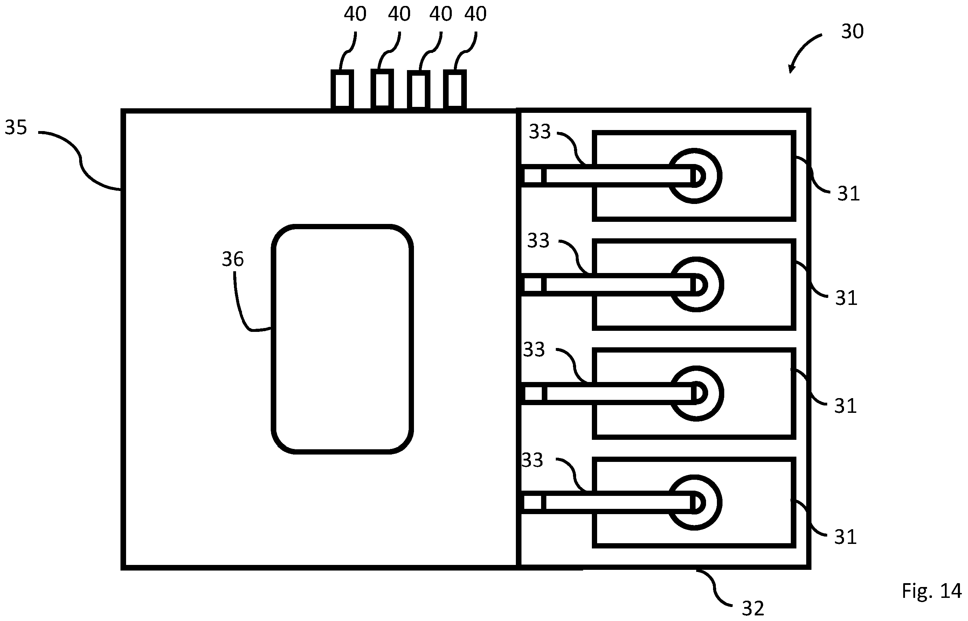

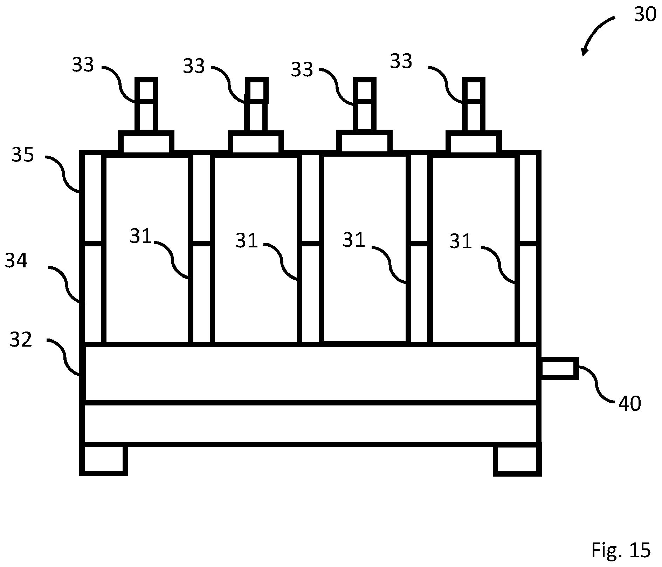

Fig. 14 zeigt den Teil des Ätzsystems 30 gemäß den Fig. 12 und 13 in Aufsicht, aus der die vier Ätzflüssigkeitsquellen 31 ersichtlich sind, die wie bereits gesagt jeweils über eine Ätzflüssigkeitsleitung 33 mit der Ventileinrichtung 39 innerhalb des Gehäuses 34 des Ätzsystems 30 verbunden sind. Über Zuführleitungen 40 kann Ätzflüssigkeit zu der erfindungsgemäßen Ätzvorrichtung 1 gefördert werden. Fig. 15 zeigt den Teil des Ätzsystems 30 der Fig. 12 bis 14 in Hinteransicht, aus der insbesondere die Anordnung der Ätzflüssigkeitsquellen 31 in der Wanne 32 hervorgeht.

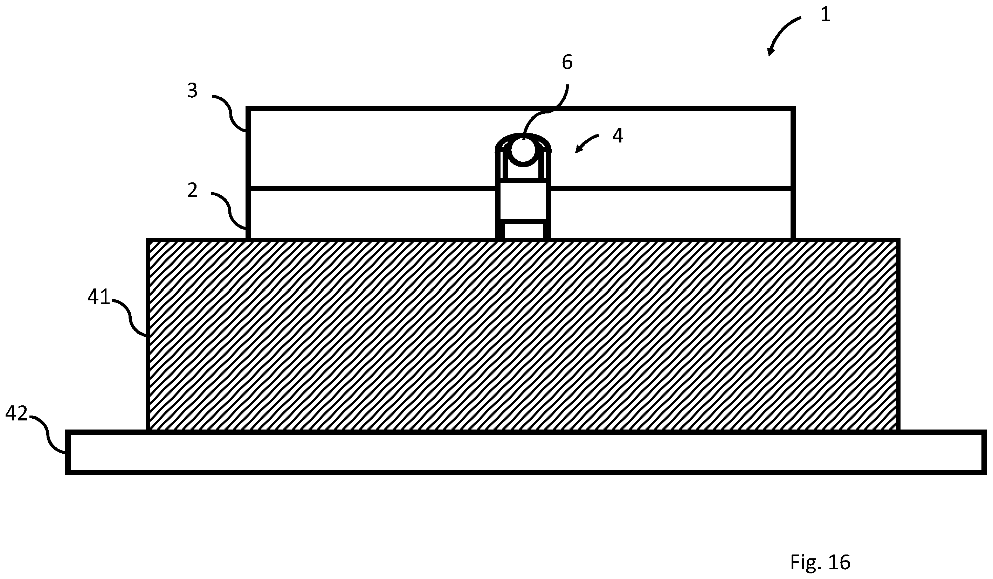

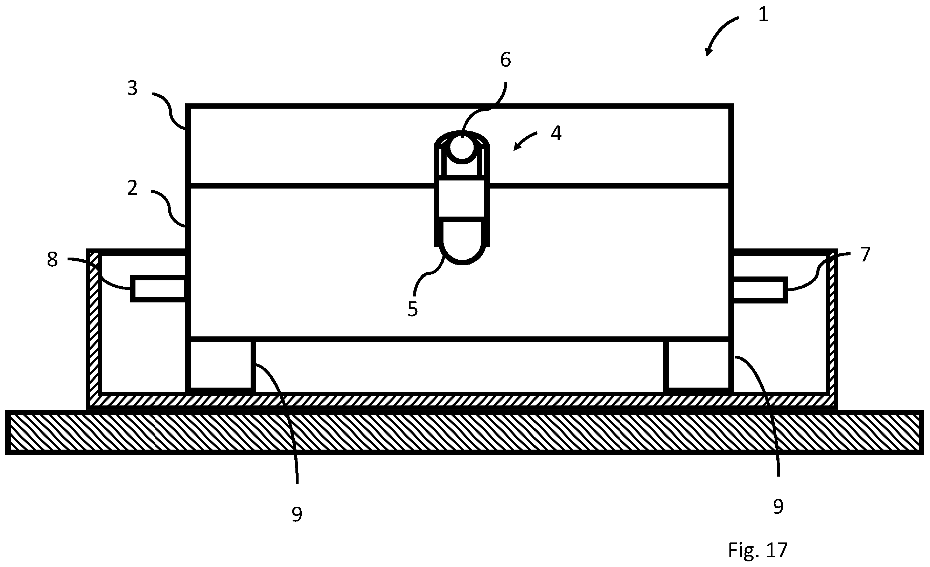

Fig. 16 zeigt ein viertes Ausführungsbeispiel der erfindungsgemäßen Ätzvorrichtung 1 in einer Seitenansicht, wobei die Ätzvorrichtung 1 in einer Auffangwanne 41 und die Auffangwanne 41 selbst auf einem Untergrund 42 angeordnet ist. Der Untergrund 42 ist im gezeigten Ausführungsbeispiel als Mikroskopiertisch ausgestaltet. Fig. 17 zeigt die Ätzvorrichtung 1 der Fig. 16 in einem schematischen Schnitt, aus dem hervorgeht, dass sich die Ätzvorrichtung über deren bereits beschriebenen Standfüßen 9 in Kontakt mit der Auffangwanne 41 befindet.

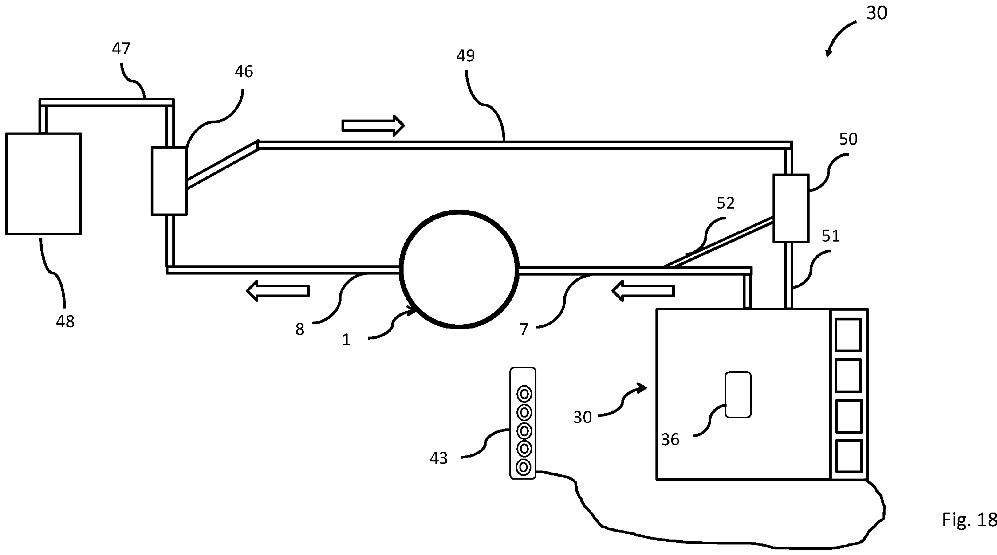

Fig. 18 zeigt das Ätzsystem 30, das teilweise bereits in Bezug auf die Fig. 12 bis 15 erläutert wurde, und mit einer erfindungsgemäßen Ätzvorrichtung 1 gemäß den Figuren 1 bis 11, in einem Ätzmittelkreislauf betrieben ist.

Gemäß Fig. 18 ist der in den Fig. 12 bis 15 gezeigte Teil des Ätzsystems 30 über eine der Zuführleitungen 40 mit der Ätzflüssigkeitszulaufleitung 7 verbunden. Mittels einer Fernbedienung 43 oder der Eingabeeinheit 36 lässt sich bereits erläuterter Weise einstellen, in welchem Volumenstrom, zu welchem Zeitpunkt oder mit welcher Temperatur eine Ätzflüssigkeit durch die Ätzflüssigkeitszulaufleitung 7 in die Ätzvorrichtung 1 gefördert werden soll.

Nach dem Ätzprozess tritt die Ätzflüssigkeit durch die Ätzmittelablaufleitung 8 wieder aus der Ätzvorrichtung 1 aus und gelangt zu einem ersten Zweiwegeventil 46. Dieses ist elektrisch steuerbar ausgebildet und in hier nicht gezeigter Weise signaltechnisch mit der Steuereinheit 37 verbunden. Mittels eines elektrischen Steuersignals lässt sich die aus der Ätzvorrichtung 1 tretende Ätzflüssigkeit wahlweise über eine Ablaufleitung 47 in ein Ätzmittelreservoir 48 leiten. Das Ätzmittelreservoir 48 erlaubt es, eine durch den Ätzprozess verunreinigte Menge an Ätzflüssigkeit aus dem Ätzsystem 30 zu führen. Es liegt im Rahmen des in Figur 18 gezeigten Ausführungsbeispiels, dass die verunreinigte Ätzflüssigkeit bedarfsweise und in Abhängigkeit einer Nutzereingabe über die Fernbedienung 43 aus dem Ätzsystem 30 geführt wird oder jedoch automatisiert und in regelmäßigen zeitlichen Abständen.

Alternativ lässt sich das erste Zweiwegeventil 46 über ein elektrisches Steuersignal derart ansteuern, dass die Ätzflüssigkeit in eine Rücklaufleitung 49 geleitet wird. Über die Rücklaufleitung 49 gelangt die Ätzflüssigkeit zu einem zweiten Zweiwegeventil 50, welches ebenfalls elektrisch steuerbar ausgestaltet und in hier nicht gezeigter Weise signaltechnisch mit der Steuereinheit 43 verbunden ist.

Über das zweite Zweiwegeventil 50 kann die in der Rücklaufleitung 49 befindliche Ätzflüssigkeit einer der Ätzmittelquellen 31 zurückgeführt werden, um anschließend weiterverwendet werden zu können. Alternativ kann die Ätzflüssigkeit über die Bypassleitung 52 unmittelbar in die Ätzmittelzulaufleitung 7 geleitet werden, ohne zuvor einer Ätzflüssigkeitsquelle 31 zugeführt werden zu müssen. Hierbei kann die Ätzflüssigkeit über die Leitungen 7, 8 und 49 zirkulieren und bei geeigneter Betätigung des ersten Zweiwegeventils 46 schließlich in das Ätzmittelreservoir 48 geleitet werden.

Wie in Bezug auf Figur 13 bereits erläutert, kann eine der Ätzflüssigkeitsquellen 31 Spülmittel, **z.B.** in der Gestalt von Alkohol enthalten, welches in oben bereits beschriebener Weise über die Ätzflüssigkeitszulaufleitung 7 in die Ätzvorrichtung 1 geführt werden kann, um den darin ablaufenden Ätzprozess zu beeinflussen. Anschließend kann das Spülmittel über die Ätzflüssigkeitsablaufleitung 8 in ebenfalls bereits beschriebener Weise über das erste Zweiwegeventil 46, die Rücklaufleitung 49, das zweite Zweiwegeventil 50 sowie die Bypassleitung 52 zu Spülzwecken in dem Ätzsystem 30 zirkulieren. Nach Abschluss eines derartigen Spülvorganges kann das Spülmittel über Ansteuerung des ersten Zweiwegeventils 46 in das Ätzmittelreservoir 48 oder ein anderes, hier nicht gezeigtes, Spülmittelreservoir abgeführt werden. In entsprechender Weise kann eine Reinigung der Ätzvorrichtung 1 erfolgen, indem bei entsprechender Ansteuerung der Steuereinheit 37 Luft aus dieser über die Ätzflüssigkeitszulaufleitung 7 in die Ätzvorrichtung 1 gelangt und von dort aus über die Ätzflüssigkeitsablaufleitung 8, das erste Zweiwegeventil 46, die Ablaufleitung 47 und schließlich zum Ätzflüssigkeitsreservoir 48 geleitet wird, von wo aus die Luft in die äußere Umgebung gelangen kann.

## Patentansprüche

1. Ätzvorrichtung (1) für ein zu bearbeitendes Werkstück (16) mittels einer Ätzflüssigkeit mit einem Hohlraum (11), in den das Werkstück (16) einbringbar ist, wobei der Hohlraum (11) zumindest bereichsweise von mindestens einer Arretierung (15) der Ätzvorrichtung (1) für das Werkstück (16) umgeben ist, wobei die Arretierung (15) und eine der Arretierung (15) zugewandte Stirnseite (14a) der Ätzvorrichtung (1) teilweise einen Zwischenraum (17) zum Einbringen der Ätzflüssigkeit umgeben und wobei die der Arretierung (15) zugewandte Stirnseite (14a) der Ätzvorrichtung (1) zumindest bereichsweise transparent ausgestaltet ist.

2. Ätzvorrichtung nach Anspruch 1, **dadurch gekennzeichnet, dass** die Arretierung (15) als mindestens ein Vorsprung (15a) zwischen dem Hohlraum (11) und dem Zwischenraum (17) ausgebildet ist, der insbesondere ringförmig ausgestaltet ist.

3. Ätzvorrichtung nach einem der Ansprüche 1 oder 2, **dadurch gekennzeichnet, dass** mindestens ein Klemmelement (13) im Hohlraum (11) derart vorgesehen ist, dass das in den Hohlraum (11) einbringbare Werkstück (16) und/oder ein in den Hohlraum (11) einbringbarer Werkstückhalter, an welchem das Werkstück (19) anbringbar ist, mit der Arretierung (15) verklemmbar ist.

4. Ätzvorrichtung nach Anspruch 3, **dadurch gekennzeichnet, dass** das Klemmelement (13) ein Federelement (13), insbesondere eine Metallfeder (13a) aufweist.

5. Ätzvorrichtung nach einem der Ansprüche 1 bis 4, **dadurch gekennzeichnet, dass** in dem Hohlraum (11) eine Werkstückaufnahme (12) angeordnet ist, um das zu bearbeitende Werkstück (16) und/oder den in den Hohlraum (11) einbringbaren Werkstückhalter, an welchem das Werkstück (19) anbringbar ist, aufzunehmen, wobei insbesondere die Wertstückaufnahme (12) das Klemmelement (13) aufweist.

6. Ätzvorrichtung nach einem der Ansprüche 1 bis 5, **dadurch gekennzeichnet, dass** ein in den Zwischenraum (17) mündender Zulaufkanal (18) für die Ätzflüssigkeit zumindest abschnittsweise in Richtung des Zwischenraums (17) verbreiternd ausgestaltet ist.

7. Ätzvorrichtung nach einem der Ansprüche 3 bis 6, **dadurch gekennzeichnet, dass** das Klemmelement (13) elektrisch leitend mit einem elektrischen Anschluss (27) verbunden ist.

8. Ätzvorrichtung nach einem der Ansprüche 1 bis 7, **dadurch gekennzeichnet, dass** vorzugsweise im Hohlraum (11) ein Heizelement (28) angeordnet ist, das dazu ausgestaltet ist, die in den Zwischenraum (17) eingebrachte Ätzflüssigkeit auf eine benutzerdefinierte Temperatur zu heizen.

9. Ätzvorrichtung nach einem der Ansprüche 1 bis 8, **dadurch gekennzeichnet, dass** eine Auflagefläche (9) der Ätzvorrichtung, die insbesondere als mindestens ein Standfuß ausgebildet ist, einen Drucksensor (9a) aufweist.

10. Ätzvorrichtung nach einem der Ansprüche 1 bis 9, **dadurch gekennzeichnet, dass** die Ätzvorrichtung (1) zweiteilig ausgestaltet ist, wobei ein Unterteil (2) der Ätzvorrichtung (1) insbesondere den Hohlraum (11) zumindest teilweise und/oder ein Oberteil (3) der Ätzvorrichtung (1) die Arretierung (15) und/oder den Zwischenraum (17) umfassen.

11. Ätzvorrichtung nach einem der Ansprüche 1 bis 10, **dadurch gekennzeichnet, dass** ein optischer Sensor (26) derart angeordnet ist, dass das in den Hohlraum (11) einbringbare Werkstück (16) zumindest teilweise durch den transparenten Bereich (14) von dem optischen Sensor (26) erfassbar ist.

12. Ätzsystem (30) mit einer Ätzvorrichtung (1) nach einem der Ansprüche 1 bis 11, wobei die Ätzvorrichtung (1) über mindestens eine Ätzflüssigkeitszulaufleitung (7) mit mindestens einer Ätzflüssigkeitsquelle (30) und über mindestens eine Ätzflüssigkeitsablaufleitung (8) mit mindestens einem Ätzflüssigkeitsreservoir (46) verbunden ist.

13. Ätzsystem nach Anspruch 12, **dadurch gekennzeichnet, dass** eine Pumpeinrichtung (38) und/oder eine Ventileinrichtung (39) mit der Ätzflüssigkeitszulaufleitung (7) und/oder mit der Ätzflüssigkeitsablaufleitung (8) verbunden sind.

14. Ätzsystem nach Anspruch 13, **dadurch gekennzeichnet, dass** die Pumpeinrichtung (38) und/oder die Ventileinrichtung (39) mit einer Steuereinheit (37) derart verbunden sind, dass die Ätzflüssigkeit mit einem benutzerdefinierten Prozessparameter in die Ätzvorrichtung (1) einbringbar ist, wobei der Prozessparameter mindestens ein Parameter der folgenden Gruppe umfasst: Zusammensetzung der Ätzflüssigkeit, Fließgeschwindigkeit der Ätzflüssigkeit, Dichte der Ätzflüssigkeit, Zeitpunkt des Zulaufs der Ätzflüssigkeit in den Zwischenraum (17), Zeitpunkt des Ablaufs der Ätzflüssigkeit in den Zwischenraum (17).

## Claims

1. An etching device (1) for a workpiece (16) to be processed by means of an etching liquid, having a cavity (11) into which the workpiece (16) can be introduced, wherein the cavity (11) is surrounded, at least in regions, by at least one stop (15) of the etching device (1) for the workpiece (16), wherein the stop (15) and an end face (14a) of the etching device (1) facing the stop (15) partially surround an intermediate space (17) for introducing the etching liquid, and wherein the end face (14a) of the etching device (1) facing the stop (15) is transparent at least in regions.

2. The etching device according to claim 1, **characterised in that** the stop (15) is formed as at least one projection (15a) between the cavity (11) and the intermediate space (17), which projection is in particular annular.

3. The etching device according to claim 1 or 2, **characterised in that** at least one clamping element (13) is provided in the cavity (11) such that the workpiece (16) that can be introduced into the cavity (11), and/or a workpiece holder that can be introduced into the cavity (11) and to which the workpiece (19) can be attached, can be clamped against the stop (15).

4. The etching device according to claim 3, **characterised in that** the clamping element (13) comprises a spring element (13), in particular a metal spring (13a).

5. The etching device according to any one of claims 1 to 4, **characterised in that** a workpiece receptacle (12) is arranged in the cavity (11) for receiving the workpiece (16) to be processed and/or the workpiece holder that can be introduced into the cavity (11) and to which the workpiece (19) can be attached, wherein in particular the workpiece receptacle (12) comprises the clamping element (13).

6. The etching device according to any one of claims 1 to 5, **characterised in that** an inlet channel (18) for the etching liquid, which opens into the intermediate space (17), widens at least in sections in the direction of the intermediate space (17).

7. The etching device according to any one of claims 3 to 6, **characterised in that** the clamping element (13) is electrically conductively connected to an electrical terminal (27).

8. The etching device according to any one of claims 1 to 7, **characterised in that** a heating element (28) is arranged, preferably in the cavity (11), which heating element is configured to heat the etching liquid introduced into the intermediate space (17) to a user-defined temperature.

9. The etching device according to any one of claims 1 to 8, **characterised in that** a support surface (9) of the etching device, which is in particular formed as at least one stand foot, comprises a pressure sensor (9a).

10. The etching device according to any one of claims 1 to 9, **characterised in that** the etching device (1) is of two-part design, wherein a lower part (2) of the etching device (1) in particular at least partially comprises the cavity (11), and/or an upper part (3) of the etching device (1) comprises the stop (15) and/or the intermediate space (17).

11. The etching device according to any one of claims 1 to 10, **characterised in that** an optical sensor (26) is arranged such that the workpiece (16) that can be introduced into the cavity (11) can be detected, at least partially, by the optical sensor (26) through the transparent region (14).

12. An etching system (30) comprising an etching device (1) according to any one of claims 1 to 11, wherein the etching device (1) is connected via at least one etching liquid supply line (7) to at least one etching liquid source (30) and via at least one etching liquid discharge line (8) to at least one etching liquid reservoir (46).

13. The etching system according to claim 12, **characterised in that** a pump device (38) and/or a valve device (39) are connected to the etching liquid supply line (7) and/or to the etching liquid discharge line (8).

14. The etching system according to claim 13, **characterised in that** the pump device (38) and/or the valve device (39) are connected to a control unit (37) such that the etching liquid can be introduced into the etching device (1) with a user-defined process parameter, wherein the process parameter comprises at least one parameter from the following group: composition of the etching liquid, flow velocity of the etching liquid, density of the etching liquid, point in time of the inflow of the etching liquid into the intermediate space (17), point in time of the outflow of the etching liquid into the intermediate space (17).

## Revendications

1. Dispositif de gravure (1) pour une pièce (16) à traiter au moyen d'un liquide de gravure, comprenant une cavité (11) dans laquelle la pièce (16) peut être introduite, la cavité (11) étant entourée, au moins par zones, par au moins une butée (15) du dispositif de gravure (1) pour la pièce (16), la butée (15) et une face frontale (14a) du dispositif de gravure (1) tournée vers la butée (15) entourant partiellement un espace intermédiaire (17) destiné à l'introduction du liquide de gravure, et la face frontale (14a) du dispositif de gravure (1) tournée vers la butée (15) étant réalisée transparente au moins par zones.

2. Dispositif de gravure selon la revendication 1, **caractérisé en ce que** la butée (15) est réalisée sous la forme d'au moins une saillie (15a) entre la cavité (11) et l'espace intermédiaire (17), ladite saillie (15a) étant en particulier de forme annulaire.

3. Dispositif de gravure selon la revendication 1 ou 2, **caractérisé en ce qu'**au moins un élément de serrage (13) est prévu dans la cavité (11) de telle sorte que la pièce (16) pouvant être introduite dans la cavité (11) et/ou un porte-pièce pouvant être introduit dans la cavité (11), sur lequel la pièce (19) peut être montée, peut être serré contre la butée (15).

4. Dispositif de gravure selon la revendication 3, **caractérisé en ce que** l'élément de serrage (13) comprend un élément formant ressort (13), en particulier un ressort métallique (13a).

5. Dispositif de gravure selon l'une quelconque des revendications 1 à 4, **caractérisé en ce qu'**un support de réception de pièce (12) est disposé dans la cavité (11) pour recevoir la pièce (16) à traiter et/ou le porte-pièce pouvant être introduit dans la cavité (11), sur lequel la pièce (19) peut être montée, le support de réception de pièce (12) comprenant en particulier l'élément de serrage (13).

6. Dispositif de gravure selon l'une quelconque des revendications 1 à 5, **caractérisé en ce qu'**un canal d'amenée (18) du liquide de gravure, débouchant dans l'espace intermédiaire (17), est réalisé de manière à s'élargir, au moins sur certaines sections, en direction de l'espace intermédiaire (17).

7. Dispositif de gravure selon l'une quelconque des revendications 3 à 6, **caractérisé en ce que** l'élément de serrage (13) est relié de manière électriquement conductrice à une borne électrique (27).

8. Dispositif de gravure selon l'une quelconque des revendications 1 à 7, **caractérisé en ce qu'**un élément chauffant (28) est disposé, de préférence dans la cavité (11), lequel est conçu pour chauffer le liquide de gravure introduit dans l'espace intermédiaire (17) à une température définie par l'utilisateur.

9. Dispositif de gravure selon l'une quelconque des revendications 1 à 8, **caractérisé en ce qu'**une surface d'appui (9) du dispositif de gravure, réalisée en particulier sous la forme d'au moins un pied d'appui, comprend un capteur de pression (9a).

10. Dispositif de gravure selon l'une quelconque des revendications 1 à 9, **caractérisé en ce que** le dispositif de gravure (1) est réalisé en deux parties, une partie inférieure (2) du dispositif de gravure (1) comprenant en particulier au moins partiellement la cavité (11) et/ou une partie supérieure (3) du dispositif de gravure (1) comprenant la butée (15) et/ou l'espace intermédiaire (17).

11. Dispositif de gravure selon l'une quelconque des revendications 1 à 10, **caractérisé en ce qu'**un capteur optique (26) est disposé de telle sorte que la pièce (16) pouvant être introduite dans la cavité (11) peut être détectée, au moins partiellement, par le capteur optique (26) à travers la zone transparente (14).

12. Système de gravure (30) comprenant un dispositif de gravure (1) selon l'une quelconque des revendications 1 à 11, le dispositif de gravure (1) étant relié, par l'intermédiaire d'au moins une conduite d'amenée de liquide de gravure (7), à au moins une source de liquide de gravure (30) et, par l'intermédiaire d'au moins une conduite d'évacuation de liquide de gravure (8), à au moins un réservoir de liquide de gravure (46).

13. Système de gravure selon la revendication 12, **caractérisé en ce qu'**un dispositif de pompage (38) et/ou un dispositif de vannes (39) sont reliés à la conduite d'amenée de liquide de gravure (7) et/ou à la conduite d'évacuation de liquide de gravure (8).

14. Système de gravure selon la revendication 13, **caractérisé en ce que** le dispositif de pompage (38) et/ou le dispositif de vannes (39) est/sont relié(s) à une unité de commande (37) de telle sorte que le liquide de gravure peut être introduit dans le dispositif de gravure (1) avec un paramètre de processus défini par l'utilisateur, le paramètre de processus comprenant au moins un paramètre du groupe suivant : composition du liquide de gravure, vitesse d'écoulement du liquide de gravure, masse volumique du liquide de gravure, instant d'arrivée du liquide de gravure dans l'espace intermédiaire (17), instant d'évacuation du liquide de gravure dans l'espace intermédiaire (17).
